# EUROPÄISCHE PATENTSCHRIFT

(11) **EP 3 153 838 B1**
(45) Veröffentlichungstag und Bekanntmachung des Hinweises auf die Patenterteilung: **06.07.2022**
(21) Anmeldenummer: 15188587.8
(22) Anmeldetag: 06.10.2015
(51) Int. Cl.: G01N 1/32, H01J 37/305

(54) **VERFAHREN ZUR PRÄPARATION EINER PROBE FÜR DIE MIKROSTRUKTURDIAGNOSTIK SOWIE PROBE FÜR DIE MIKROSTRUKTURDIAGNOSTIK**
METHOD FOR PREPARING A SAMPLE FOR THE MICROSTRUCTURE DIAGNOSIS AND SAMPLE FOR MICRO STRUCTURE DIAGNOSIS
PROCÉDÉ DE PRÉPARATION D'UN ÉCHANTILLON POUR LE DIAGNOSTIC DE MICROSTRUCTURE ET ÉCHANTILLON POUR LE DIAGNOSTIC DE MICROSTRUCTURE

(43) Veröffentlichungstag der Anmeldung: 12.04.2017
(73) Patentinhaber: Fraunhofer-Gesellschaft zur Förderung der angewandten Forschung e.V., 80686 München (DE)
(72) Erfinder: Krause, Michael, 06108 Halle (DE); Busch, Richard, 06114 Halle (DE); Höche, Thomas, 06120 Halle (DE); Schusser, Georg, 06198 Salzatal (DE)
(74) Vertreter: Patentanwälte Ruff, Wilhelm, Beier, Dauster & Partner mbB

(56) Entgegenhaltungen:
- WO-A1-2011/101613
- DE-B4-102004 001 173
- US-A1- 2006 186 336
- US-B2- 8 134 124

## Beschreibung

### ANWENDUNGSGEBIET UND STAND DER TECHNIK

Die Erfindung betrifft ein Verfahren zur Präparation einer Probe für die Mikrostrukturdiagnostik, worin durch materialabtragende Bearbeitung an einem Probenkörper ein Probenabschnitt präpariert und anschließend an dem Probenabschnitt ein Untersuchungsbereich erzeugt wird, welcher einen zu untersuchenden Zielbereich umfasst. Die Erfindung betrifft auch eine Probe für die Mikrostrukturdiagnostik, die mithilfe des Verfahrens präpariert werden kann.

Ein bevorzugtes Anwendungsgebiet ist die Präparation von Proben für die Mikrostrukturdiagnostik mittels Transmissionselektronenmikroskopie (TEM). Für die Mikrostrukturdiagnostik mittels Transmissionselektronenmikroskopie geeignete Proben werden hier auch als TEM-Proben bezeichnet.

Für die Präparation von Proben für die Mikrostrukturdiagnostik werden Techniken gesucht, die möglichst zielgenau, artefaktarm, zuverlässig und schnell sind. TEM-Proben benötigen einen Probenabschnitt mit einem relativ dünnen, elektronentransparenten Untersuchungsbereich, also einem Untersuchungsbereich, der mittels Elektronenstrahl durchstrahlbar ist. Der zu untersuchende Zielbereich sollte diesem elektronentransparenten Untersuchungsbereich liegen. Der Zielbereich ist derjenige räumlich begrenzte Bereich, der für die Untersuchung von Interesse ist.

Eine Abdünnung auf rein mechanischem Wege ist zwar insbesondere bei Keramiken und Halbleitern im Prinzip relativ artefaktarm möglich, erfordert jedoch großes handwerkliches Geschick, um zumindest ansatzweise zu reproduzierbarer Probenqualität zu führen. Darüber hinaus gibt es bereits eine Vielzahl teilweise sehr komplexer Technologien zur Erzeugung ausreichend dünner, elektronentransparenter Bereiche an TEM-Proben. Dazu zählen insbesondere das mechanische Vordünnen (Schleifen, Polieren, Muldenschleifen), dem sich ein lonenstrahlätzprozess anschließt, das Herausschneiden von Dünnschnitten mit einem fokussierten lonenstrahl (Focussed Ion Beam, FIB), sowie die Ultramikrotomie.

Es sind auch schon Verfahren zur TEM-Probenpräparation vorgeschlagen worden, die mit einer Kombination aus Laserstrahlbearbeitung und lonenstrahlbearbeitung arbeiten. Beispielsweise beschreibt die DE 10 2004 001 173 B4 ein Verfahren zur Präparation von TEM-Proben, bei dem von einem Substrat eines Probenmaterials Material mittels Ultrakurzpulslaserablation in einer Vakuumkammer derart abgetragen wird, dass ein schmaler Steg verbleibt, der anschließend unter flachem Winkel mit Edelgas-Ionen beschossen wird, so dass im Bereich des Steges ein elektronentransparenter Bereich entsteht.

Zurzeit wird davon ausgegangen, dass für die Präparation von TEM-Proben die laserbasierte Probenpräparation aufgrund der nicht zu vernachlässigenden Lasereinflussschicht nur ein erster Schritt sein kann, dem ein schädigungsärmerer zweiter Schritt folgen sollte, in welchem die Elektronenstrahltransparenz hergestellt wird. Dieser zweite Schritt wird typischerweise unter Nutzung eines fokussierten lonenstrahls (FIB) oder eines lonenbreitstrahls (Broad Ion Beam, BIB) durchgeführt.

Die Bearbeitung mittels eines fokussierten lonenstrahls (FIB-Bearbeitung) und die Breitstrahlbearbeitung (BIB-Bearbeitung) unterscheiden sich unter anderem hinsichtlich der aufzuwendenden Kosten. Während eine Breitstrahlionenätzanlage zu moderaten Anschaffungskosten kommerziell erhältlich ist, außer Strom und Ätzgas sowie Wartungskosten kaum Folgekosten aufwirft und von technischem Personal problemlos bedient werden kann, schlägt die Anschaffung einer Anlage zur FIB-Bearbeitung mit vielfach höheren Anschaffungskosten zu Buche, ist im Unterhalt wesentlich teuer und erfordert einen deutlich besser ausgebildeten Bediener als ein lonenbreitstrahlätzgerät.

Mittels FIB hergestellte Proben und lonenbreitsstrahlpräparate unterscheiden sich zudem klar in der zugänglichen Geometrie. Aufgrund der relativ geringen Dosis sind Gesamtvolumen-Abtragraten von FIB-Strahlen deutlich niedriger als die von lonenbreitstrahlanlagen. Damit sind der FIB-Technik bezüglich der zugänglichen Probendimensionen praktische Grenzen gesetzt - typische FIB-Lamellen für die Untersuchung mittels TEM sind heutzutage z.B. 20 × 5 × 0,5 µm³ groß.

Andererseits kommt der Untersuchung großflächiger TEM-Präparate eine immer größere Bedeutung zu. Dies gilt z.B. im Hinblick auf die TEM-Untersuchung von 3D-integrierten mikroelektronischen Bauelementen. Hier versucht man, durch materialabtragende Bearbeitung, z.B. mittels Laserstrahlbearbeitung, aus einem Probenkörper einen relativ großflächigen, dünnen Probenabschnitt zu präparieren und anschließend in dem Probenabschnitt einen elektronentransparenten Untersuchungsbereich zu erzeugen, welcher einen zu untersuchenden Zielbereich umfasst.

Das Dokument US 2006/0186336 A1 beschreibt ein Verfahren zur Präparation einer Probe für die Mikrostrukturdiagnostik, bei dem in einem Substrat zunächst eine Kerbe mit schräg zur Oberfläche verlaufenden Flanken erzeugt wird, wobei die Kerbe um einen Zielbereich herum verläuft. Nach der Erzeugung der Kerbe wird ein lonenstrahl schräg zur Substratoberfläche eingestrahlt, um den durch die umlaufende Kerbe umschlossenen Innenbereich, der den zu untersuchenden Zielbereich umfasst, durch Hinterschnitt vom Substrat zu lösen.

Die Patentschrift DE 10 2004 001 173 B4 beschreibt ein Verfahren zur Präparation von Materialproben für die Transmissionselektronenmikroskopie durch Abtragen des Materials mittels Ultrakurzlaserablation in einer Vakuumkammer in einer Weise, dass ein schmaler Steg verbleibt und anschließend der verbliebene Steg unter flachem Winkel mit Edelgas-Ionen beschossen wird, so dass der Steg elektronentransparent ist.

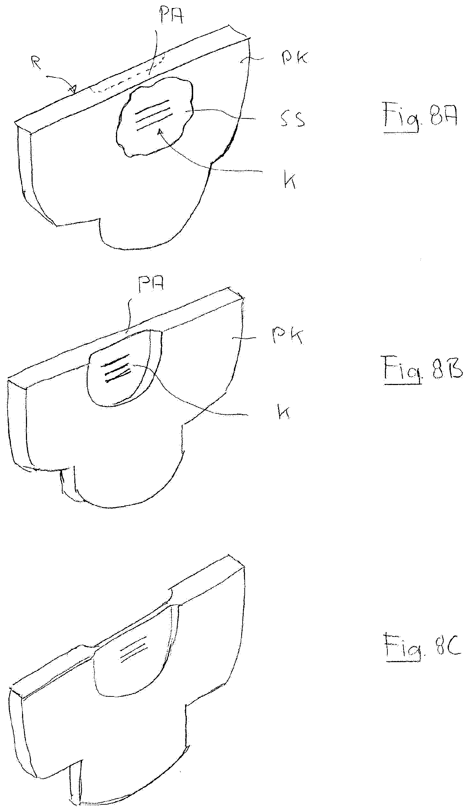

Das Dokument WO 2011/101613 A1 beschreibt ein Verfahren und eine Vorrichtung zum lonenstrahlpolieren. Bei einer in Zusammenhang mit Figur 8 erläuterten Verfahrensvariante zum Herstellen einer Probe für die Mikrostrukturdiagnostik wird die zu bearbeitende Probe auf einem als Probehalter dienenden Stab fixiert. An einer Seite der Probe wird ein Abschirmungselement ("shield") befestigt, das einen Teil der Probe gegen den eingestrahlten lonenstrahl abschirmt, so dass nur ein oberhalb der Abschirmung liegender Anteil der Probe frei bleibt, um durch lonenstrahl abgetragen zu werden. Über der Oberkante der Abschirmung entsteht eine durch lonenstrahl polierte Oberfläche, die parallel zur Einstrahlrichtung des lonenstrahls ausgerichtet ist. Zwischen dieser Oberfläche und dem noch nicht abgetragenen Bereich existiert eine sichtbare Grenze in Form einer schrägen Stufe.

Die Patentschrift US 8,134,124 B2 beschreibt Verfahren zur Herstellung von Proben für die Mikrostrukturdiagnostik mittels Transmissionselektronenmikroskopie. Bei einer Verfahrensvariante, die unter anderem im Zusammenhang mit den Figuren 18 und 19 beschrieben wird, wird aus einem Substrat durch Einstrahlung eines lonenstrahls eine dünne Lamelle erzeugt, indem beidseitig neben der zu präparierenden Lamelle kastenförmige Bereiche ("milled boxes") durch lonenstrahlen beseitigt werden. Die Ionenstrahlung wird dabei so gesteuert, dass die Abtragrate in der Nähe der Lamelle, d.h. im Bereich der gewünschten Oberflächen der Lamelle, größer ist als in größerem Abstand davon, so dass beidseitig neben den zu präparierenden Oberflächen der Lamelle am Substrat zur Lamelle hin abfallende Schrägflächen entstehen.

### AUFGABE UND LÖSUNG

Es ist eine Aufgabe der Erfindung, ein Verfahren der eingangs erwähnten Art bereitzustellen, mit welchem es möglich ist, in vorpräparierten Probenabschnitten lateral gezielt und in relativ kurzer Zeit unter möglichst geringer Schädigung des zu untersuchenden Materials Bedingungen zu schaffen, die es ermöglichen, einen interessierender Zielbereich mittels eines Verfahrens der Mikrostrukturdiagnostik, insbesondere mittels Transmissionselektronenmikroskopie, zu untersuchen. Es ist eine weitere Aufgabe, eine Probe für die Mikrostrukturdiagnostik, insbesondere mittels Transmissionselektronenmikroskopie, bereitzustellen, die in einem vorgebbaren Zielbereich einen für die Untersuchung geeigneten, schädigungsarm präparierten Untersuchungsbereich aufweist.

Zur Lösung dieser Aufgabe stellt die Erfindung ein Verfahren mit den Merkmalen von Anspruch 1 bereit. Weiterhin wird die Aufgabe gelöst durch eine Probe mit den Merkmalen von Anspruch 14. Vorteilhafte Weiterbildungen sind in den abhängigen Ansprüchen angegeben. Der Wortlaut sämtlicher Ansprüche wird durch Bezugnahme zum Inhalt der Beschreibung gemacht.

Bei dem Verfahren wird an mindestens einer Oberfläche des Probenabschnitts eine Terrassenbildungszone erzeugt, die den zu untersuchenden Zielbereich umfasst bzw. enthält. Zur Erzeugung der Terrassenbildungszone wird neben dem Zielbereich, also lateral versetzt zum Zielbereich, durch materialabtragende Strahlbearbeitung mindestens eine Kerbe erzeugt, die schräg zu der Oberfläche verlaufende Flanken hat. Der Begriff "Kerbe" bezeichnet hierbei einen von der Oberfläche in die Tiefe des Probenabschnitts eingebrachten Einschnitt, welcher in einer vorgebbaren Verlaufsrichtung verläuft und welcher in der Regel eine in Verlaufsrichtung gemessene Länge hat, die vielfach größer ist als die senkrecht zur Verlaufsrichtung messbare Breite der Kerbe. Eine Kerbe (notch) kann ggf. auch als Scharte bezeichnet werden. Mit dem Begriff "schräg" wird eine Richtung oder Orientierung bezeichnet, die in einem bestimmten Winkel von einer (gedachten) Linie oder Ebene abweicht, also eine nicht-parallele Orientierung. Hierzu gehört eine senkrechte Orientierung genauso wie davon abweichende schräge Orientierungen. Eine Kerbe kann z.B. im Querschnitt eine V-Form aufweisen oder annähernd senkrecht zur Oberfläche orientierten Flanken haben.

Bei hinreichend dünnem Probenabschnitt und entsprechender Tiefe der Kerbe kann die Kerbe von einer Oberfläche zur gegenüberliegenden Oberfläche des Probenabschnitts nach Art eines durchgehenden Schlitzes hindurchgehen. Es ist auch möglich, dass die Kerbe nach Art eines Grabens oder einer Nut innerhalb des Probenabschnitts endet und somit eine Tiefe hat, die geringer ist als die Dicke des Probenabschnitts am entsprechenden Ort. Die Flanken der Kerbe können mehr oder weniger senkrecht zur Oberfläche oder in einem deutlich von 90° abweichenden schrägen Winkel dazu verlaufen und gehen im Bereich der angrenzenden Oberfläche unter Bildung einer mehr oder weniger ausgeprägten Kante in die Oberfläche über. Der Winkel zwischen Oberfläche und Flanke im Bereich der Kante kann z.B. im Bereich zwischen 90° und 75° liegen.

Nach Abschluss der Kerbenerzeugungs-Operation wird in einem weiteren Verfahrensschritt Material des Probenabschnitts im Bereich der Terrassenbildungszone mittels eines lonenstrahls von der Oberfläche abgetragen. Der lonenstrahl wird dabei unter streifendem Einfall (relativ kleiner Winkel zur Oberfläche) sowie schräg zu einer Verlaufsrichtung der Kerbe auf die Oberfläche eingestrahlt. Die Einstrahlrichtung des lonenstrahls kann senkrecht zur Verlaufsrichtung der Kerbe oder abweichend von der senkrechten Orientierung schräg dazu verlaufen und ist so gewählt, dass der Zielbereich in Einstrahlrichtung des lonenstrahls hinter der Kerbe liegt.

Es kann sich bei dem lonenstrahl z.B. um einen fokussierten lonenstrahl (FIB) oder um einen lonenbreitstrahl (BIB) handeln.

Unter diesen Einstrahlbedingungen des lonenstrahls kommt es innerhalb der Terrassenbildungszone zu einer Ausbildung von Terrassen, welche sich im zeitlichen Verlauf im Wesentlichen in Einstrahlrichtung des lonenstrahls ausbreiten. Diese Topographieentwicklung resultiert nach den Erkenntnissen der Erfinder unter anderem aus unterschiedlichen Ätzraten des Probenmaterials in Abhängigkeit vom lokalen Auftreffwinkel der Ionen des lonenstrahls im Bereich derjenigen Flanke der Kerbe, die dem Zielbereich näher liegt und die vom lonenstrahl am Übergang zwischen Flanke und Oberfläche, also im Bereich ihrer Kante, direkt bestrahlt wird. Diese Flanke wird hier auch als "hintere Flanke" bezeichnet, weil sie, in Strahlrichtung des lonenstrahls betrachtet, hinter der ihr gegenüberliegenden Flanke liegt, welche weiter entfernt vom Zielbereich liegt und hier auch als "vordere Flanke" bezeichnet wird.

Aufgrund des streifenden Einfalls (relativ kleiner Winkel (z.B. weniger als 15°) zwischen der Oberfläche des Probenabschnitts und der Einstrahlrichtung des lonenstrahls) und der Orientierung der hinteren Flanke schräg zur Oberfläche treffen die Ionen des lonenstrahls mehr oder weniger senkrecht auf denjenigen oberen Abschnitt der hinteren Flanke, der durch die gegenüberliegende Flanke (vordere Flanke) nicht abgeschattet wird. Gleichzeitig treffen die unter streifendem Einfall eingestrahlten Ionen unter einem sehr flachen Winkel relativ zur Oberfläche auf die Oberfläche hinter der Kerbe, also auf der dem Zielbereich zugewandten Seite der Kerbe. Bei den typischerweise stark vom Einfallswinkel abhängigen Ätzraten der lonenstrahlbearbeitung führen diese Unterschiede der Auftreffwinkel zu einem mehrfach schnelleren Ausbreiten von Terrassen in Richtung parallel zur ursprünglichen Oberfläche, als diese in der Tiefe fortschreiten. Somit entsteht im Bereich der Kerbe eine Art Stufe in der Oberfläche in der Weise, dass die Oberfläche in Einstrahlungsrichtung gesehen hinter der Kerbe stärker abgetragen wurde und damit tiefer liegt als im Bereich vor der Kerbe. Die Stufe verlagert sich mit zunehmender Bestrahlungszeit von der Kerbe weg.

Die Höhe der Stufe, also der Niveauunterschied zwischen den Oberflächenbereichen vor und hinter der Kerbe, ist dabei im Wesentlichen eine Funktion des Einfallswinkels des lonenstrahls und der in Einstrahlrichtung gemessenen effektiven Breite der Kerbe. Dabei ist die Stufenhöhe größer, je größer die effektive Breite der Kerbe am jeweiligen Ort ist. Aufgrund der Terrassenbildung im Bereich hinter einer Kerbe wird die Oberfläche im Wesentlichen parallel zur ursprünglichen Höhe der Oberfläche durch lonenstrahlbearbeitung zurückgesetzt, so dass auf diese Weise ein durch die Geometrie der Anordnung exakt definierbares, gleichmäßiges Rücksetzen der Oberfläche des Probenabschnitts gegenüber dem ursprünglichen Niveau der Oberfläche erzielt werden kann.

Bei TEM-Proben kann dadurch bei geeigneter Verfahrensführung erreicht werden, dass der Probenabschnitt einerseits im interessierenden Zielbereich dünn genug für die TEM-Untersuchung ist, andererseits aber im unmittelbaren Zielbereich keinen durch die lonenstrahlbearbeitung verursachtes Loch enthält. Ein derartiges Abdünnen ist unter anderem aus Stabilitätserwägungen vorteilhaft und bietet die Möglichkeit, relativ große, elektronentransparente Untersuchungsbereiche und/oder elektronentransparente Untersuchungsbereiche an mehreren zuvor definierten Positionen zu erzeugen.

Auch bei Proben für andere Untersuchungsverfahren der Mikrostrukturdiagnostik, z.B. bei Proben für die Röntgenmikroskopie (X-ray microscopy, XRM) oder für die Atomsonden-Tomographie (APT), kann das Verfahren vorteilhaft eingesetzt werden. Hier muss der Untersuchungsbereich nicht elektronentransparent sein, sondern das zuvor beschriebe Vorgehen kann im Wesentlichen ausschließlich dazu verwendet werden, das durch eine Vorpräparation eventuell geschädigte Material des oberflächennahen Bereichs zu entfernen.

Bei einer Weiterbildung ist das Verfahren dafür ausgelegt, eine Probe zu präparieren, die für eine Mikrostrukturdiagnostik mittels Transmissionselektronenmikroskopie (TEM) geeignet ist, wobei in dem Probenabschnitt ein elektronentransparenter Untersuchungsbereich, also ein mittels Elektronenstrahl durchstrahlbarer Untersuchungsbereich, erzeugt wird, in welchem der Zielbereich liegt. Der Untersuchungsbereich kann z.B. eine Dicke bzw. Materialstärke im Bereich von wenigen Nanometern (z.B. 10 nm) bis zu einigen 100 nm (z.B. bis zu 0.5 µm) aufweisen.

Bei bevorzugten Ausführungsformen des Verfahrens wird die Kerbe durch Laserstrahlbearbeitung in die Oberfläche des Probenabschnitts eingebracht. Mit der Lasermikrobearbeitung steht ein Instrument zur Verfügung, mit dem in einem beispielsweise durch Laserbearbeitung vorbearbeiteten dünnen Probenabschnitt gezielt Kerben (durchgehend oder nicht durchgehend) so eingebracht werden können, dass davon ausgehende Terrassen präzise über die Oberfläche des Probenabschnitts geleitet werden können. Alternativ ist es auch möglich, eine Kerbe mithilfe eines lonenstrahls einzubringen, beispielsweise eines fokussierten lonenstrahls (FIB). Damit können ggf. Kerben mit geringeren Breiten und Tiefen erzeugt werden als bei Laserstrahlbearbeitung. Die FIB-Bearbeitung kann z.B. für eine finale Dünnung von noch wenige 100 nm dicken FIB-Lamellen vorteilhaft sein.

Es kann ausreichen, wenn in die Terrassenbildungszone nur eine einzige Kerbe eingebracht wird. Häufig werden jedoch in der Terrassenbildungszone mehrere mit lateralem Abstand zueinander verlaufende Kerben erzeugt, die z.B. parallel zueinander liegen können. Der laterale Abstand kann senkrecht zur Verlaufsrichtung der Kerben gemessen werden. Durch eine Kerbenschar mit zwei oder mehr zueinander versetzt liegenden Kerben wird es möglich, durch die lonenstrahlbearbeitung ein Vielfaches der an einer einzelnen Kerbe entstehenden Stufenhöhe zu erzeugen, wenn die Ätzzeit (Bestrahlungszeit) so gewählt wird, dass die Stufen sich über mehrere Kerben hinweg bewegen bzw. ausbreiten können. Dadurch kann eine sukzessive Absenkung einer Oberfläche um ein Vielfaches der an einer einzelnen Kerbe erzielbaren Terrassenstufenhöhe erzielt werden.

Die Anzahl von Kerben in der Terrassenbildungszone ist prinzipiell nicht limitiert. Im Sinne einer Begrenzung der Herstellungszeit für die Kerbe, der gegenseitigen Beeinflussung des abgetragenen Materials und der Stabilität hat es sich jedoch als sinnvoll erwiesen, nur eine relativ geringe Anzahl von Kerben für einen entsprechenden Zielbereich vorzusehen, beispielsweise zwei, drei, vier, fünf oder sechs Kerben.

Der gegenseitige Abstand zueinander versetzter Kerben, z.B. zueinander paralleler Kerben, kann als weiterer Einflussparameter zur Kontrolle des Prozesses genutzt werden. Prinzipiell können die Stufen schneller erzeugt werden, je geringer der Abstand zwischen benachbarten Kerben ist. Andererseits kann durch zu eng liegende Kerben die Stabilität der Probe beeinträchtigt werden. Ein Abstand zwischen benachbarten Kerben, gemessen senkrecht zur generellen Verlaufsrichtung der Kerben, kann an die Breite der Kerben in dieser Richtung angepasst sein. Der Abstand kann z.B. zwischen dem Doppelten und dem Zehnfachen, insbesondere zwischen dem Doppelten bis Fünffachen der Breite einer einzelnen Kerbe liegen, ggf. auch darüber.

Über die Gestalt und Dimensionierung der Kerben kann Einfluss auf den Ablauf des Abdünnens genommen werden. Dabei hat beispielsweise die an der Oberfläche gemessene Breite einer Kerbe entscheidenden Einfluss auf die an der Kerbe entstehende Stufenhöhe zwischen vorgelagerter Oberfläche und nachfolgender Oberfläche. Es hat sich als vorteilhaft erwiesen, wenn die Kerbe, Z.B. mittels Laserstrahlbearbeitung, derart erzeugt wird, dass eine (an der Oberfläche gemessene) Breite der Kerbe in einem Bereich von ca. 10 µm bis ca. 50 µm liegt. Dies ergibt bei typischen Einfallswinkeln von lonenstrahlen in kommerziellen lonenstrahlbearbeitungsanlagen (zum Beispiel zwischen 4° und 10° bezogen auf die Oberfläche) nützliche Stufenhöhen im Bereich einiger Mikrometer pro Kerbe. Beispielsweise wird unter der Annahme eines lonenstrahleinfallswinkels von 80° (gemessen zur Oberflächennormalen) eine Kerbe mit einer Breite von 15 µm bei lonenbestrahlung senkrecht zur Verlaufsrichtung der Kerbe zu einer Stufenhöhe von ca. 2,5 µm führen.

Insbesondere in solchen Fällen hat es sich als vorteilhaft erwiesen, wenn ein Abstand zwischen unmittelbar benachbarten Kerben im Bereich von 20 µm bis 100 µm liegt, insbesondere im Bereich von ca. 50 µm bis ca. 80 µm. Hierdurch kann ein guter Kompromiss zwischen hinreichend schneller Bearbeitungszeit und ausreichender Stabilität erzielt werden.

Ist eine Kerbe nur ca. 250 nm breit, würde sich unter den gleichen Einstrahlbedingungen eine Stufenhöhe von ca. 44 nm ergeben. Derart schmale Kerben (z.B. von ca. 50 nm bis ca. 250 nm Breite) können z.B. durch FIB-Bearbeitung erzeugt werden. Der Bereich günstiger Abstände benachbarter Kerben wäre entsprechend kleiner. Hier könnten z.B. Abstände im Bereich von 200 nm bis 500 nm günstig sein.

Eine Kerbe kann über ihre gesamte Länge eine (im Rahmen der prozessbedingten Schwankungen) im Wesentlichen konstante Breite aufweisen. Dies ist jedoch nicht zwingend. Bei manchen Verfahrensvarianten wird mindestens eine Kerbe erzeugt, welche eine in Verlaufsrichtung variierende Breite aufweist. Eine Kerbe kann beispielsweise eine oder mehrere lokale Verbreiterungsbereiche aufweisen oder in Draufsicht eine keilförmige Gestalt derart haben, dass sich die Breite entlang der Verlaufsrichtung kontinuierlich vergrößert oder verkleinert. Dadurch ist es möglich, entlang des Verlaufs einer Kerbe lokal unterschiedliche Abtraghöhen zu erzielen, die durch den Breitenverlauf vorgegeben werden können. Vorzugsweise sollte zwischen dieser Kerbe und dem Zielbereich keine weitere Kerbe liegen. Dadurch können unterschiedliche Abtraghöhen besonders genau vorgegeben werden.

In vielen Fällen werden in der Terrassenbildungszone eine oder mehrere Kerben mit geradlinigem Verlauf erzeugt. Diese sind besonders einfach herstellbar. Ein geradliniger Verlauf ist jedoch nicht zwingend. Bei manchen Verfahrensvarianten wird mindestens eine Kerbe erzeugt, welche einen nicht-geradlinigen Verlauf mit wechselnder Verlaufsrichtung aufweist. Die Kerbe kann beispielsweise einen bogenförmigen Verlauf oder einen Verlauf in Form eines Halbkreises haben. Es ist auch möglich, dass eine Kerbe einen schlangenlinienförmigen Verlauf oder einen allgemein hin- und hergehenden Verlauf aufweist. Bei einer Kerbe mit im Wesentlichen konstanter Breite ergeben sich aufgrund der entlang des Verlaufs der Kerbe wechselnden Orientierung der Kerbenabschnitte in Bezug auf die Einstrahlrichtung des lonenstrahls unterschiedliche effektiven Breiten der Kerbe (gemessen parallel zur Einstrahlrichtung des lonenstrahls), wodurch in den Bereichen hinter den Kerbenabschnitten auch unterschiedliche Abtraghöhen bzw. Stufenhöhen erzielbar sind. Durch Vorgabe bestimmter nicht-geradliniger Verläufe von Kerben kann somit die örtliche Verteilung von Abtraghöhen gezielt gesteuert werden. Vorzugsweise sollte zwischen dieser Kerbe mit nicht-geradlinigen Verlauf und dem Zielbereich keine weitere Kerbe liegen. Dadurch können unterschiedliche Abtraghöhen besonders genau vorgegeben werden.

Es ist möglich, mithilfe des Verfahrens nur eine einzige Oberfläche eines Probenabschnitts stufenartig abzusenken. In manchen Fällen ist vorgesehen, bei der Kerbenerzeugungs-Operation den Probenabschnitt beidseitig zu bearbeiten, so dass sowohl an einer ersten Oberfläche des Probenabschnitts als auch an einer gegenüberliegenden zweiten Oberfläche des Probenabschnitts mindestens eine Kerbe eingebracht wird, so dass auf beiden Seiten des Probenabschnitts jeweils eine Terrassenbildungszone entsteht, und dass danach an der ersten und der zweiten Oberfläche mittels eines lonenstrahls unter streifendem Einfall Material im Bereich der Terrassenbildungszone in der beschriebenen Weise abgetragen wird. Hierdurch kann die Bearbeitungszeit bis zur fertigen Probe weiter verkürzt werden.

Es ist möglich, dass es bei der Erzeugung der Kerben, beispielsweise mittels Laserstrahlbearbeitung, zu Ablagerungen auf der Oberfläche in der Nähe der erzeugten Kerbe oder im Kantenbereich am Übergang zwischen Flanke und Oberfläche kommt. Untersuchungen haben gezeigt, dass derartige Debris-Ablagerungen zu raueren Abtragflächen führen können. Eine Möglichkeit zur Vermeidung derartiger Probleme besteht darin, dass vor der materialabtragenden Strahlbearbeitung zur Erzeugung einer Kerbe eine Schutzschicht auf die Oberfläche aufgebracht wird, dass danach die Kerbe in dem Probenabschnitt durch die Schutzschicht hindurch erzeugt wird und dass danach die Schutzschicht von der Oberfläche wieder entfernt wird. Eventuelle Ablagerungen setzen sich dann auf der Schutzschicht ab und können mit dieser entfernt werden, so dass im Bereich der Kerben sehr saubere Kanten zwischen Flanke der Kerbe und anschließender Oberfläche sowie sehr saubere Oberflächen ohne Ablagerungen vorliegen. Die Abtragbedingungen beim nachfolgenden lonenstrahlbearbeiten lassen sich hierdurch besonders genau und über die Länge der Kerbe gleichmäßig gestalten.

Es ist möglich, das Abtragen von Material mittels lonenstrahls als statischen Prozess in der Weise durchzuführen, dass sich die Einstrahlrichtung des lonenstrahls über die gesamte Einstrahlzeit nicht ändert. Hierdurch sind genau definierte geometrische Bedingungen im Bereich der Kerben vorgebbar. Es kann jedoch auch sinnvoll sein, beim Abtragen des Materials mittels lonenstrahls die Einstrahlrichtung des lonenstrahls in Azimutalrichtung und/oder in Vertikalrichtung während des Abtragens periodisch oder aperiodisch über einen entsprechenden Einfallswinkelbereich zu variieren, beispielsweise über einen Einfallswinkelbereich von ± 5° um eine Haupt-Einstrahlrichtung. Dadurch kann beispielsweise der unerwünschte Effekt eines "curtaining" vermieden werden, also eine Ausbildung von wellenartigen Strukturen an der Oberfläche ausgehend von Orten verringerter Abtragraten.

Die Erfindung betrifft auch eine Probe für die Mikrostrukturdiagnostik, wobei die Probe insbesondere durch das in dieser Anmeldung beschriebene Verfahren erhältlich ist oder erhalten wurde.

Die Probe hat einen Probenabschnitt, der einen Untersuchungsbereich aufweist, welcher einen zu untersuchenden Zielbereich umfasst. An mindestens einer Oberfläche des Probenabschnitts befindet sich neben dem Untersuchungsbereich mindestens eine Kerbe mit schräg zu der Oberfläche verlaufenden Flanken. Ein Oberflächenniveau an der dem Untersuchungsbereich abgewandten Seite der Kerbe ist höher als das Oberflächenniveau im Untersuchungsbereich. Alternativ oder zusätzlich kann eine Probendicke an der dem Untersuchungsbereich abgewandten Seite der Kerbe größer sein als die Probendicke im Untersuchungsbereich.

### KURZBESCHREIBUNG DER ZEICHNUNGEN

Weitere Vorteile und Aspekte der Erfindung ergeben sich aus den Ansprüchen und aus der nachfolgenden Beschreibung von bevorzugten Ausführungsbeispielen der Erfindung, die nachfolgend anhand der Figuren erläutert sind.
Fig. 1 zeigt eine schräge Draufsicht auf ein Ausführungsbeispiel einer Probe für die Mikrostrukturdiagnostik mittels Transmissionselektronenmikroskopie während einer Phase des Präparationsprozesses;
Fig. 2 zeigt schematisch die zeitliche Entwicklung einer Terrassenentstehung beim lonenstrahlätzen unter streifendem Einfall eines lonenstrahls im Bereich einer Kerbe;
Fig. 3A bis 3C zeigen den Effekt einer sukzessiven Absenkung einer Oberfläche um ein Vielfaches einer einzelnen Terrassenstufenhöhe an mehreren aufeinander folgenden Kerben;
Fig. 4A und 4B zeigen die Ergebnisse eines beispielhaften Experiments anhand einer lichtmikroskopischen Aufnahme der Oberfläche eines Probenabschnitts, in die drei zueinander parallele Kerben durch Laserstrahlbearbeitung eingebracht wurden (Fig. 4A) und eines Diagramm einer laserprofilometrischen Ausmessung der stufigen Oberflächenstruktur nach Abschluss der lonenbestrahlung (Fig. 4B);
Fig. 5A und Fig. 5B zeigen unterschiedliche Möglichkeiten zur Erzeugung von Kerben an beiden Seiten eines relativ dünnen Probenabschnitts;
Fig. 6A und Fig. 6B zeigen in Fig. 6A eine schematische Draufsicht auf einen Ausschnitt einer Oberfläche eines Probenabschnitts und in Fig. 6B einen senkrechten Schnitt durch den Probenabschnitt entlang der Linie B-B in Fig. 6A;
Fig. 7 zeigt schematisch eine Draufsicht auf eine mit Kerben versehene Oberseite eines Probenabschnitts gemäß einem anderen Ausführungsbeispiel;
Fig. 8A bis Fig. 8C zeigen verschiedene Möglichkeiten, eine Kerbenerzeugungs-Operation in den Gesamtprozess der Probenpräparation einzubinden;
Fig. 9 zeigt ein Ausführungsbeispiel, bei dem Kerben als in Verlaufsrichtung unterbrochene Kerben gestaltet sind;
Fig. 10 zeigt ein Ausführungsbeispiel mit halbkreisförmig um einen Zielbereich angeordneten Kerben und azimutaler Variation der Einstrahlrichtung des lonenstrahls;
Fig. 11 zeigt ein Ausführungsbeispiel, bei dem ein plattenartiger Probenabschnitt beidseitig mit unterschiedlich orientierten Kerben versehen ist und mit lonenstrahlen aus angepassten unterschiedlichen Richtungen bearbeitet wird;
Fig. 12 zeigt schematisch die Präparation einer rotationssymmetrischen Probe für die Untersuchung der Mikrostruktur mit Hilfe der Atomsonden-Tomographie (APT) oder der Röntgentomographie bzw. Röntgenmikroskopie (XRM);
Fig. 13 zeigt schematisch eine andere Präparation einer rotationssymmetrischen Probe für die Untersuchung der Mikrostruktur mit Hilfe der Atomsonden-Tomographie oder der Röntgentomographie bzw. Röntgenmikroskopie; und
Fig. 14 zeigt schematisch die Präparation einer FIB-Lamelle, wobei eine Kerbe neben einem Zielbereich mittels eines fokussierten lonenstrahls erzeugt wird.

### DETAILLIERTE BESCHREIBUNG DER AUSFÜHRUNGSBEISPIELE

Im Folgenden werden verschiedene Aspekte von beispielhaften Verfahren gemäß der beanspruchten Erfindung erläutert. Den Verfahren gemeinsam ist eine gezielte Einbringung von mikroskaligen oder nanoskaligen Kerben bzw. Scharten in einen Probenabschnitt, um dadurch definierte Abtragprozesse durch eine nachfolgende lonenstrahlbearbeitung zu erzielen.

Aus Gründen der Übersichtlichkeit und Verständlichkeit werden gleiche oder ähnliche Elemente in den verschiedenen Ausführungsbeispielen zum Teil mit den gleichen Bezugszeichen bezeichnet.

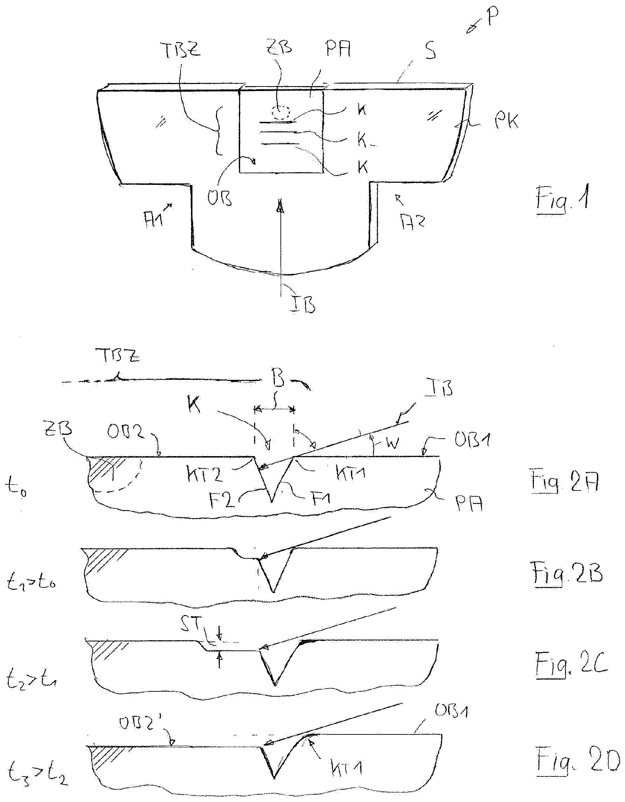

In Fig. 1 ist eine schräge Draufsicht auf ein Ausführungsbeispiel einer Probe P für die Mikrostrukturdiagnostik mittels Transmissionselektronenmikroskopie (TEM) während einer Phase des Präparationsprozesses bzw. Herstellungsprozesses der Probe gezeigt. Die auch als TEM-Probe bezeichnete Probe hat einen im Wesentlichen plattenförmigen Probenkörper PK, der mittels Laserbearbeitung aus einem größeren Materialstück des zu untersuchenden Materials herauspräpariert wurde. Der generell plattenförmige Probenkörper, der z.B. einer Dicke von ca. 100 µm bis 150 µm oder bis 250 µm haben kann, hat etwa die Grundform eines Halbkreises. Gegenüber einer kreishalbierenden Seite S sind zwei dreieckförmige Aussparungen A1, A2 vorgesehen, die durch zwei senkrecht zueinander ausgerichtete Kanten begrenzt sind. Diese Geometrie erleichtert die lagerichtige Anbringung des Probenkörpers bzw. der gesamten Probe in einem hier nicht näher beschriebenen Klemmhalter, in dem die Probe bzw. der Probenkörper für verschiedene Bearbeitungsschritte des Präparationsprozesses fixiert werden kann. Die Geometrie des Probenkörpers ähnelt der Geometrie von Proben, welche in der EP 2 787 338 A1 zusammen mit der Funktion der Aussparung beschrieben ist. Insoweit wird auf die dortige Beschreibung verwiesen.

An der den Aussparungen gegenüberliegenden Seite S ist etwa mittig an der Kreishalbierenden ein im Wesentlichen plattenförmiger Probenabschnitt PA mittels Laserbearbeitung aus dem Material des Probenkörpers herauspräpariert. Der Probenabschnitt PA hat etwa die Form einer planparallelen Lamelle, deren (senkrecht zur Plattenausdehnung gemessene) Dicke beispielsweise im Bereich von 10 bis 20 µm liegen kann. Innerhalb dieses Probenabschnitts PA liegt der Zielbereich ZB der Probe, also derjenige Bereich, der nach Abschluss der Probenpräparation mithilfe eines Transmissionselektronenmikroskops im Hinblick auf seine Mikrostruktur und andere Eigenschaften untersucht werden soll.

Bei TEM-Proben ist es ein Ziel des Verfahrens, in dem Probenabschnitt PA einen für Elektronenstrahlen durchlässigen, d.h. einen elektronentransparenten Untersuchungsbereich zu erzeugen, der den Zielbereich ZB einschließt, so dass dieser untersucht werden kann. Eine Elektronentransparenz lässt sich bei vielen Materialien erreichen, wenn im Untersuchungsbereich eine Restdicke in der Größenordnung von 10 nm oder einigen 10 nm, maximal wenigen 100 nm, vorzugsweise weniger als 1 µm, verbleibt.

Die Erzeugung der Elektronentransparenz soll möglichst zielgerichtet sein, die Probe nicht oder nur in vernachlässigbarer Weise schädigen und insgesamt nur möglichst wenig Bearbeitungszeit erfordern. Dazu ist es im Beispielsfall nicht erforderlich, den gesamten, im Vergleich zum interessierenden Zielbereich wesentlich größeren Probenabschnitt PA zur Elektronentransparenz zu bringen, sondern es reicht aus, eine Zielpräparation in nur einem kleinen Ausschnitt des Probenabschnitts durchzuführen. Zudem wird unter anderen aus Stabilitätserwägungen angestrebt, den lamellenartig dünnen Probenabschnitt PA möglichst planparallel abzudünnen, so dass die Probe im Zielbereich ZB dünn genug für die TEM-Untersuchung ist, sich aber unmittelbar am Zielbereich kein Loch befindet. Mit der hier beschriebenen Verfahrensvariante kann dieses Ziel systematisch bzw. reproduzierbar erreicht werden.

Während des Verfahrens wird im Beispielsfall an der in Fig. 1 sichtbaren ebenen Oberfläche OB des Probenabschnitts PA eine Terrassenbildungszone TBZ erzeugt, die anschließend mit einem lonenstrahl IB (z.B. Ar⁺ - lonen-Breitstrahl) unter streifendem Einfall bestrahlt wird, um innerhalb der Terrassenbildungszone gezielt stufenweise Material abzutragen. Details hierzu werden im Zusammenhang mit den Fig. 1 und 2A bis 2D näher erläutert.

Zum Erzeugen der Terrassenbildungszone wird neben dem Zielbereich ZB durch materialabtragende Strahlbearbeitung mithilfe eines Lasers mindestens eine Kerbe K mit schräg zu der Oberfläche OB verlaufenden Flanken F1, F2 erzeugt (vgl. Fig. 2A). Im Beispiel von Fig. 1 wurden neben dem Zielbereich ZB drei zueinander parallele geradlinige Kerben K1, K2, K3 erzeugt, die in der (durch einen Pfeil dargestellten) Einstrahlrichtung des lonenstrahls IB gesehen einen Abstand zueinander haben.

Nach Abschluss der Kerbenerzeugungs-Operation wird Material des Probenabschnitts PA im Bereich der Terrassenbildungszone TBZ mithilfe eines lonenstrahls IB abgetragen, der unter streifendem Einfall schräg, ggf. etwa senkrecht, zur Verlaufsrichtung der Kerben derart auf die Oberfläche OB eingestrahlt wird, dass der Zielbereich ZB in Einstrahlrichtung (siehe Pfeile in Fig. 1) hinter der Kerbe K1, K2, K3 bzw. K liegt.

Fig. 2 zeigt die Verhältnisse im Bereich einer Kerbe K der Terrassenbildungszone TBZ zu verschiedenen Zeitpunkten der lonenstrahlbearbeitung. Daraus ist die Terrassenentstehung beim lonenstrahlätzen unter streifendem Einfall eines lonenstrahls im Bereich der Kerbe anschaulich erkennbar.

Fig. 2A zeigt einen schematischen Schnitt durch einen Probenabschnitt PA senkrecht zu dessen ebener Oberfläche im Bereich einer Kerbe K, die im Beispielsfall senkrecht zur Zeichnungsebene geradlinig verläuft. Die Kerbe K hat eine senkrecht zur Oberfläche gemessene Tiefe, die geringer ist als die in dieser Richtung gemessene Dicke des Probenabschnitts, so dass die Kerbe nicht zur gegenüberliegenden Oberfläche durchgeht. Die im Querschnitt im Wesentlichen V-förmige Kerbe hat eine schräg zur Oberfläche verlaufende erste Flanke F1 und eine gegenüberliegende, ebenfalls schräg zur Oberfläche verlaufende zweite Flanke F2, die V-förmig aufeinander zulaufen und sich im Kerbengrund treffen. Die schrägen Flanken gehen jeweils im Bereich einer zugeordneten Kante (erste Kante KT1, zweite Kante KT2) in die daran angrenzenden Oberflächenbereiche (erster Oberflächenbereich OB1, zweiter Oberflächenbereich OB2) über.

Die Kerbe hat auf dem Niveau der Oberfläche eine senkrecht zur Verlaufsrichtung gemessene Breite B, die z.B. zwischen 10 µm und 30 µm betragen kann. Ähnlich wie die drei Kerben K1, K2 und K3 in Fig. 1 ist die Kerbe K für den Schritt der Materialabtragung durch lonenbestrahlung in Bezug auf die Einstrahlrichtung (Pfeil) des lonenstrahls IB so ausgerichtet, dass der lonenstrahl im Wesentlichen senkrecht zur Verlaufsrichtung (Längsrichtung) der Kerben eingestrahlt wird.

Der lonenstrahl IB wird unter streifendem Einfall eingestrahlt, was hier bedeutet, dass zwischen der ursprünglichen Oberfläche OB und der Einstrahlrichtung des lonenstrahls nur ein relativ kleiner Winkel W von beispielsweise weniger als 15° eingeschlossen ist. Dieser Winkel kann insbesondere im Bereich von 4° bis 10° liegen. Dieser in einer senkrecht zur Oberfläche liegenden Ebene gemessene Winkel wird hier in Anlehnung an die Verhältnisse bei der Röntgenbeugung auch als Glanzwinkel W bezeichnet. Davon zu unterscheiden ist der lonenauftreffwinkel IAW. Als lonenauftreffwinkel IAW wird hierbei derjenige Winkel bezeichnet, den die Einstrahlrichtung des lonenstrahls mit der Normalen zur Oberfläche am Auftreffpunkt auf die jeweilige Oberfläche einschließt. Im Bereich unmittelbar vor der vorderen Kante KT1 ergibt sich der lonenauftreffwinkel IAW als Ergänzungswinkel zu 90° zum Glanzwinkel W. Auf die hinteren Flanke F2 trifft der lonenstrahl fast senkrecht auf, was bezogen auf die Normale zur hinteren Flanke einem lonenauftreffwinkel nahe 0° entspricht.

Unter diesen Einstrahlbedingungen beobachtet man innerhalb der Terrassenbildungszone TBZ jeweils im Bereich hinter einer Kerbe eine Ausbildung einer Terrasse, welche sich, wie in den Fig. 2A bis 2D gezeigt, im Wesentlichen in Richtung parallel zur Einstrahlrichtung ausbreitet. Diese Topographieentwicklung resultiert in erster Linie daraus, dass die lonenätzrate bei praktisch allen relevanten Materialien in Abhängigkeit vom lonenauftreffwinkel relativ stark variiert. Bei vielen Materialien weist die Abtragrate bei lonenbestrahlung im Bereich von lonenauftreffwinkeln zwischen ca. 50° und ca. 75° ein Maximum auf und nimmt ausgehend von diesem Maximum zu kleineren und größeren lonenauftreffwinkel-Werten in materialspezifischer Weise immer mehr ab, wobei sich häufig die Abtragrate im Maximum um einen Faktor 2 bis 10 von der minimalen Abtragrate unterscheidet. Beispielsweise wurde in: Völlner, B. Ziberi, F. Frost, und B. Rauschenbach, Topography evolution mechanism on fused silica during low-energy ion beam sputtering, J. Appl. Phys. 109, 043501 (2011) die Abhängigkeit der Quarzglas-Sputterabtragrate vom lonenauftreffwinkel bestimmt und es wurde gezeigt, dass unter den genutzten Bedingungen die maximale Ätzrate für einen lonenauftreffwinkel von ca. 75° erreicht wurde. Sie nimmt zu größeren Auftreffwinkeln (bis hin zum streichenden Einfall bei 90°) als auch zu kleineren lonenauftreffwinkeln (bis hin zum senkrechten Einfall bei lonenauftreffwinkel gleich 0°) stark ab. Die Abhängigkeit der Sputterabtragrate vom lonenauftreffwinkel bei Silizium wurde beispielsweise in: A. Barna, Mat. Res. Soc. Proc. 254 (1992) 3-22 beschrieben. Dort liegt die maximale Ätzrate bei einem lonenauftreffwinkel von ca. 55° und die Abtragrate nimmt zu kleineren und größeren Werten deutlich ab.

Verfahren gemäß der beanspruchten Erfindung nutzen diese Abhängigkeit in besonderer Weise. Die in Fig. 2 schematisch dargestellte Topographieentwicklung mit Terrassenausbildung resultiert in erster Linie aus den unterschiedlichen Ätzraten im Bereich der hinteren Kante KT2, bei welcher die dem Zielbereich ZB nähere hintere Flanke F2 der Kerbe K in die angrenzende Oberfläche OB2 übergeht. Im Bereich dieser Kante trifft der streifend einfallende lonenstrahl IB nahezu senkrecht auf die hintere Flanke F2 auf, wodurch sich eine relativ hohe Abtragrate einstellt. Im Gegensatz dazu treffen die Ionen auf die angrenzende Oberfläche OB2 relativ flach auf, d.h. in einem relativ großen lonenauftreffwinkel (z.B. zwischen 80° und 86°) relativ zur Oberflächennormalen. Diese Unterschiede führen zu einem deutlich schnelleren Ausbreiten der Terrasse in Richtung des Zielbereichs (in Fig. 2 nach links) als in die Tiefenrichtung (in Fig. 2 nach unten). Diejenige (hintere) Kante KT2, an der die Terrassenbildung einsetzt, wird hier auch als "Initialkante" für die Terrassenentstehung bezeichnet.

Fig. 2A zeigt die Situation zu Beginn der lonenbestrahlung zum Zeitpunkt t₀, wobei hier noch kein nennenswerter Materialabtrag im Bereich der Flanken stattgefunden hat. Zu einem späteren Zeitpunkt t₁>t₀ (siehe Fig. 2B) hat der Materialabtrag im Bereich der Initialkante bereits eingesetzt und es schiebt sich eine Stufe mit immer größerem Abstand zur Kerbe A in Richtung des Zielbereichs ZB. Zu einem späteren Zeitpunkt t₂>t₁ (Fig. 2C) ist die Stufe weiter vorangeschritten und es bildet sich eine immer breiter werdende Terrasse auf einem Niveau unterhalb des ursprünglichen Höhenniveaus der zweiten Oberfläche OB2. Bei weiter fortschreitender lonenbestrahlung hat sich zum Zeitpunkt t₃>t₂ (Fig. 2D) die Stufe aus dem dargestellten Bereich in Richtung Zielbereich ZB herausbewegt. Das Höhenniveau der dadurch erzeugten Oberfläche OB2' liegt unterhalb des Höhenniveaus der ursprünglichen Oberfläche OB2, wobei der Niveauunterschied durch die Stufenhöhe ST gegeben ist, die im Wesentlichen über den Glanzwinkel des lonenstrahls und die in Strahlrichtung wirksame Breite B der Kerbe bestimmt wird.

Zur Größenabschätzung können folgende Überlegungen dienen. Typische Laserstrahldurchmesser können sich beispielsweise im Bereich von 10 µm bis 20 µm bewegen, so dass Kerben mit Breiten B in etwa dieser Größe mithilfe eines fokussierten Laserstrahls erzeugt werden können. Unter der Annahme eines lonenauftreffwinkels von 80° (bezogen auf die Oberflächennormale der Oberfläche OB) bzw. eines Glanzwinkels W von ca. 10° führt eine 15 µm breite Kerbe bei lonenbestrahlung normal zur Linienrichtung der Kerbe zu einer Stufenhöhe ST von ca. 2,5 µm.

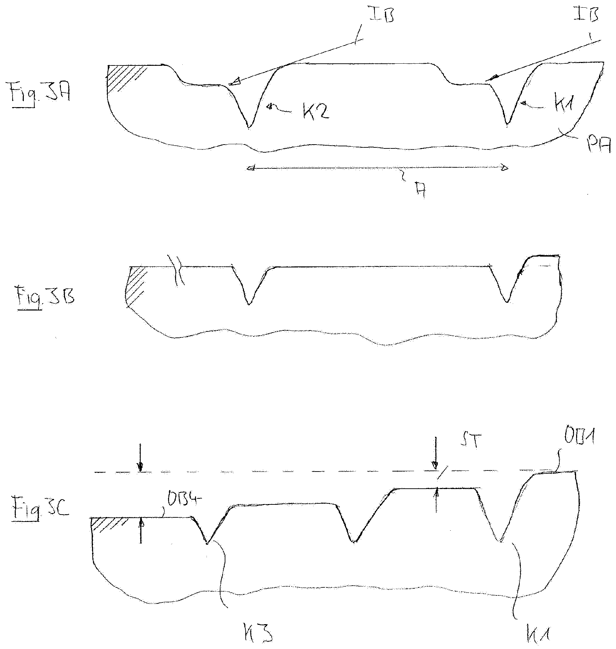

Es möglich, einen Materialabtrag um ein Vielfaches einer an einer einzelnen Kerbe erzielbaren Stufenhöhe zu erzielen. Anhand der Fig. 3A bis 3C wird der entsprechende Effekt einer sukzessiven Absenkung einer Oberfläche um ein Vielfaches einer einzelnen Terrassenstufenhöhe beispielhaft erläutert. Fig. 3A zeigt hierzu einen schematischen Schnitt durch einen Probenabschnitt PA, in welchem zwei zueinander parallele Kerben K1, K2 durch Laserstrahlbearbeitung eingebracht wurden. Bei schräger Bestrahlung unter einem lonenstrahl IB tritt an jeder Kerbe der im Zusammenhang mit Fig. 2 erläuterte Effekt einer Terrassenbildung hinter der in Einstrahlrichtung hinteren Flanke auf. Der Abstand A unmittelbar aufeinanderfolgender Kerben kann beispielsweise im Bereich von 50 bis 80 µm liegen, gegebenenfalls auch darunter (beispielsweise bis hinunter zu 20 µm) oder darüber (beispielsweise bis 100 µm oder darüber). Wird nun die Ätzzeit, d.h. die Bestrahlungsdauer der lonenbestrahlung, so gewählt, dass sich die hinter den einzelnen Kerben ausbildenden Stufen über mehrere aufeinanderfolgende Kerben hinweg ausbreiten können (siehe Fig. 3B), so ist es möglich, die Absenkung einer Oberfläche um ein Vielfaches der an einer Kerbe erzielbaren Stufenhöhe zu erreichen. Im Beispiel von Fig. 3C ist das Niveau der Oberfläche OB4 hinter der dritten Kerbe K3 gegenüber dem Niveau der Oberfläche OB1 vor der ersten Kerbe K1 etwa um das Dreifache der Stufenhöhe ST abgesenkt, welche sich an einer einzelnen Kerbe ergibt.

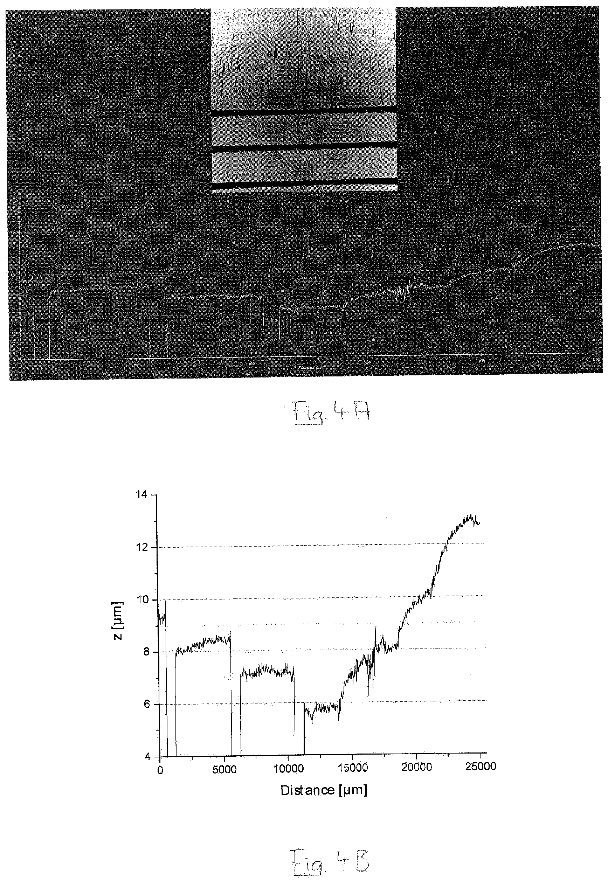

Experimentelle Untersuchungen der Erfinder belegen, dass die hier schematisch dargestellten Vorgänge in der Praxis zu dem gewünschten Ergebnis führen können. Hierzu sind in Fig. 4A und 4B die Ergebnisse eines beispielhaften Experiments anschaulich dargestellt. Dabei zeigt Fig. 4A eine lichtmikroskopische Aufnahme der Oberfläche eines Probenabschnitts, in die drei zueinander parallele Kerben (schwarz erscheinende Striche) durch Laserstrahlbearbeitung eingebracht wurden. Nach Bestrahlung mit einem lonenbreitstrahl haben sich Stufen gebildet. Fig. 4B zeigt das Diagramm einer laserprofilometrischen Ausmessung einer über drei parallele Kerben ausgebreiteten Terrasse mit einer Gesamtabsenkung der hintersten Oberfläche um ca. das Dreifache der an einer einzelnen Kerbe erzielbaren Einzelstufenhöhe. Fig. 4B belegt anschaulich, dass durch Einbringen von drei zueinander parallelen Kerben ein Absenken der hinter der letzten Kerbe liegenden Oberfläche gegenüber der vor der ersten Kerbe liegenden Oberfläche um das Dreifache einer Einzelstufenhöhe erzielbar ist.

Obwohl es möglich ist, mithilfe des Verfahrens nur eine einzige Oberfläche eines Probenabschnitts stufenweise abzusenken, ist es in vielen Fällen vorgesehen, bei der Kerbenerzeugungs-Operation den Probenabschnitt beidseitig zu bearbeiten, so dass sowohl an einer ersten Oberfläche des Probenabschnitts als auch an einer gegenüberliegenden zweiten Oberfläche des Probenabschnitts mindestens eine Kerbe eingebracht wird, so dass auf beiden Seiten des Probenabschnitts jeweils eine Terrassenbildungszone entsteht, und dass danach an der ersten und der zweiten Oberfläche mittels eines lonenstrahls unter streifendem Einfall Material im Bereich der Terrassenbildungszone in der beschriebenen Weise abgetragen wird. Dies kann z.B. sinnvoll sein, wenn auf beiden Seiten des Probenabschnitts Schädigungszonen durch ionenstrahlbasierten Tiefenabtrag entfernt werden sollen. Die Ausdehnung beispielsweise durch Ultrakurzpulslaserbearbeitung entstandener, struktureller Schädigung ist typischerweise im Bereich unterhalb von 2 µm und damit genau in der Größenordnung einer reproduzierbar erzielbaren Stufenhöhe.

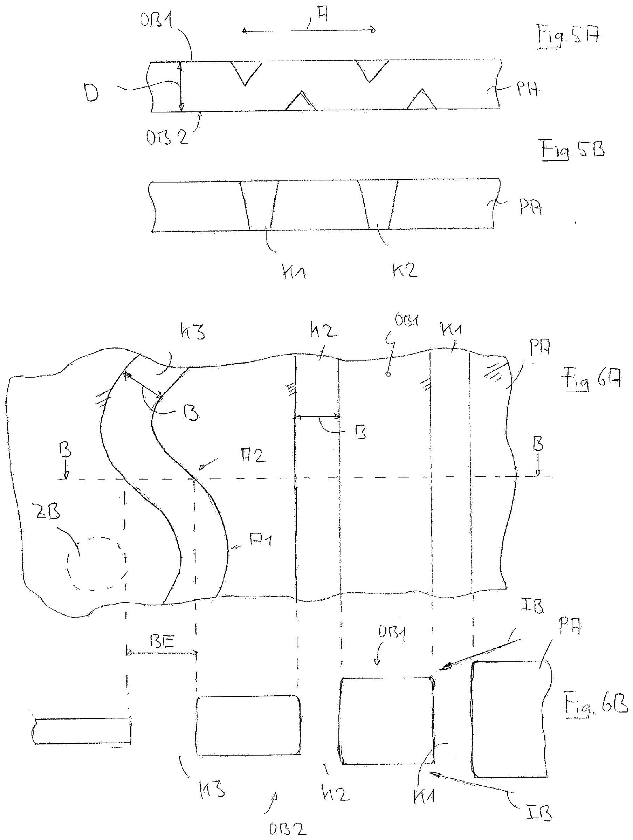

Beispielhaft zeigen Fig. 5A und Fig. 5B unterschiedliche Möglichkeiten zur Erzeugung von Kerben an beiden Seiten eines relativ dünnen Probenabschnitts PA, der im Beispielsfall eine zwischen den Oberflächen OB1 und OB2 gemessene Dicke D im Bereich von ca. 10 bis 15 µm hat. Wie in Fig. 5A gezeigt ist, können an beiden Oberflächen jeweils nutartige Kerben eingebracht werden, die nicht zur gegenüberliegenden Seite durchgehen, sondern die Oberflächen jeweils nur anritzen. Bei einer beidseitigen Anbringung nicht durchgehender Kerben, wie sie in Fig. 5A schematisch skizziert ist, kann es im Sinne der Stabilität der Probe zweckmäßig sein, wenn diese einander nicht unmittelbar gegenüberliegend angeordnet sind, sondern gegeneinander versetzt, so dass einer Kerbe an einer Seite keine Kerbe einer gegenüberliegenden Seite gegenüberliegt. Wie in Fig. 5B gezeigt, ist es auch möglich, zum Beispiel mittels Laserstrahlbearbeitung Kerben K1, K2 in den Probenabschnitt PA so einzubringen, dass die Kerben von der ersten Oberfläche OB1 zur zweiten Oberfläche OB2 hindurchgehen. Bei derartigen hindurchgehenden Kerben kann sowohl die Eintrittsöffnung als auch die Austrittsöffnung zur Ausbildung von Terrassen an der jeweiligen Oberfläche dienen.

Wie bereits erwähnt, sollte im Falle von mehreren hintereinander angeordneten Kerben deren Abstand A möglichst gering sein, um innerhalb kurzer Ätzzeiten die gewünschte Absenkung des Oberflächenniveaus zu erreichen. Andererseits sollte der Abstand nicht so klein werden, dass die Stabilität des bearbeiteten Probenabschnitts merklich beeinträchtigt wird. Typische Abstände in einer Größenordnung von ca. 20 µm bis ca. 100 µm haben sich als besonders praktikabel herausgestellt, wobei dies jedoch nicht limitierend verstanden werden soll.

In Fig. 6 ist ein anderes Ausführungsbeispiel gezeigt, wobei Fig. 6A eine schematische Draufsicht auf einen Ausschnitt einer Oberfläche eines Probenabschnitts PA und Fig. 6B einen senkrechten Schnitt durch den Probenabschnitt entlang der Linie B-B in Fig. 6A zeigt. Eine Besonderheit dieses Ausführungsbeispiels besteht darin, dass die dem Zielbereich ZB nächste Kerbe K3 einen schlangenlinienförmigen Verlauf hat, während die in lonenstrahlrichtung davor angeordneten Kerben K1, K2 jeweils geradlinig und parallel zueinander verlaufen. Die Kerben gehen jeweils vollständig durch den dünnen Probenabschnitt PA hindurch, so dass sowohl an der ersten Oberfläche OB1 als auch an der gegenüberliegenden zweiten Oberfläche OB2 eine Terrassenbildungszone entsteht.

Wie Fig. 6B zeigt, werden nach der Kerbenerzeugungs-Operation beide Oberflächen durch lonenstrahlbearbeitung unter streifendem Einfall eines lonenbreitstrahls IB bearbeitet und dadurch stufenweise zurückgesetzt. Alle Kerben K1, K2, K3 haben die gleiche Breite B gemessen senkrecht zu ihrer Verlaufsrichtung, beispielsweise definiert durch die Mittellinien der jeweiligen Kerben. Bei den Kerben K1 und K2 entspricht diese Breite B auch der effektiven Breite, die sich in Einstrahlrichtung des lonenstrahls (Pfeilrichtung) ergibt. Bei der schlangenlinienförmigen dritten Kerbe K3 variiert jedoch die in Einstrahlrichtung gemessene effektive Breite BE in Abhängigkeit davon, an welcher Stelle entlang der Kerbe die effektive Breite gemessen wird. In denjenigen ersten Kerbenabschnitten A1, die im Wesentlichen parallel zu den anderen Kerben K1, K2 und damit senkrecht zur Einstrahlrichtung verlaufen, entspricht die effektive Breite BE der Breite B der Kerbe. In den zweiten Kerbenabschnitten A2, die aufgrund der Schlangenlinienform schräg zur Einstrahlrichtung verlaufen, ist die effektive Breite BE größer als die Breite B. Damit variiert die Stufenhöhe bzw. Abtraghöhe hinter der dritten Kerbe K3 räumlich zwischen einer minimalen Stufenhöhe, die der Stufenhöhe an den anderen beiden Kerben K1, K2 entspricht, und maximalen Stufenhöhen, die sich in den Bereichen ergibt, die z.B. um 45° gegenüber der Einstrahlrichtung schräggestellt verlaufen. Hinter den schräg verlaufenden zweiten Kerbenabschnitten A2 ergibt sich also ein stärkerer Materialabtrag (größere Abtragtiefe).

Dieser Effekt kann dazu genutzt werden, den Prozess des Abtragens im Sinne einer Dickenbestimmung zu überwachen und bei Erreichen einer gewünschten Zieldicke im Zielbereich ZB zu beenden. Zum Zwecke der Dickenbestimmung kann der Bereich hinter der dem Zielbereich nächsten schlangenlinienförmigen Kerbe K3 optisch oder auf andere Weise auf Lochbildung überwacht werden. Bei gleichmäßiger lonenbestrahlung werden diejenigen Bereiche hinter der schlangenlinienförmigen Kerbe K3, die hinter den schräg orientierten zweiten Kerbenabschnitten A2 liegen, stärker abgetragen als benachbarte Bereiche, die hinter den ersten Kerbenabschnitten A2 kleinerer effektiver Breite liegen. Somit wird die Lochbildung zunächst hinter den zweiten Kerbenabschnitten A2 einsetzen, während benachbart dazu noch eine Restdicke an Probenmaterial verbleibt. Der Materialabtrag mittels lonenstrahl kann gestoppt werden, sobald die Bildung eines Lochs beobachtet wird. Die Lage der Kerbe K3 mit nicht-geradlinigem Verlauf sowie die Lage der besonders schräg stehenden zweiten Kerbenabschnitte können nun so aneinander angepasst werden, dass der Zielbereich hinter einem Abschnitt mit geringerem Materialabtrag liegt, so dass in diesem Abschnitt keine Lochbildung stattfindet, die Restdicke aber gleichwohl ausreichend gering ist, um Elektronenstrahltransparenz zu zeigen.

Die Beobachtung einer Lochbildung in gezielt vorgegebenen Bereichen neben dem Zielbereich kann somit zur In-Line-Dickenmessung genutzt werden.

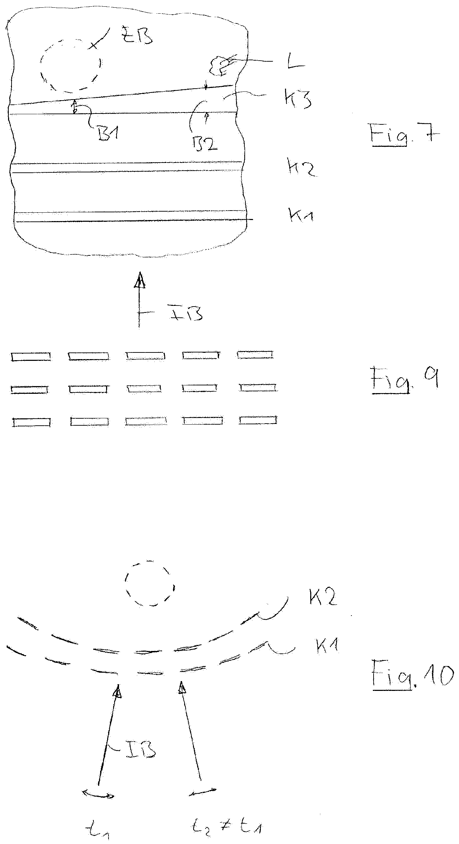

Fig. 7 zeigt schematisch eine Draufsicht auf eine mit Kerben versehene Oberseite eines Probenabschnitts gemäß eines anderen Ausführungsbeispiels. In diesem Fall hat die dem Zielbereich ZB nächstliegende dritte Kerbe K3 eine in Verlaufsrichtung variierende Breite, wobei die Breite im Beispielsfall von links nach rechts kontinuierlich zunimmst, so dass in Draufsicht eine keilförmige Gestalt der Kerbe vorliegt. Nach den vorhergehenden Erläuterungen ist einleuchtend, dass der Materialabtrag in dem Bereich mit der größeren Breite B2 bei Einstrahlung des lonenstrahls IB in Einstrahlrichtung (Pfeil) größer sein wird als hinter dem schmaleren Abschnitt mit Breite B1, hinter welchem sich der Zielbereich ZB befindet. Somit würde sich bei lonenbestrahlung und zunehmender Ausdünnung des dünnen Probenabschnitts zunächst hinter dem breiteren Kerbenabschnitt mit Breite B2 ein Loch L bilden, während im Zielbereich die angestrebte Restdicke mit Elektronentransparenz verbleibt.

Es gibt verschiedene Möglichkeiten, die Kerbenerzeugungs-Operation in den Gesamtprozess der Probenpräparation einzubinden. Anhand von Fig. 8A bis 8C werden einige Beispiele dargestellt.

Bei der Variante in Fig. 8A werden die Kerben K einseitig in den Probenkörper PK eingebracht, bevor der dünnere Probenabschnitt PA durch Laserbearbeitung des Probenkörpers erzeugt wird. Die Kerben werden also im Ausschneidestadium, d.h. bei noch nicht auf ca. 10 bis 20 µm nachgedünntem Probenabschnitt, einseitig eingebracht. Die spätere Rückdünnung erfolgt dann von der gegenüberliegenden Rückseite R, was durch gestrichelte Linien dargestellt ist. Es kann von beiden Seiten gedünnt werden, dies ist aber nicht zwingend. Diese Variante bietet die Möglichkeit, denjenigen Bereich, in welchen Kerben eingebracht werden sollen, also die Terrassenbildungszone, vor dem Einbringen der Kerben mit einer Schutzschicht SS zu beschichten, durch die hindurch dann die Kerben eingebracht werden. Mithilfe der Schutzschicht kann die Ablagerung von Bearbeitungsrückständen (Debris) an den Rändern der Kerbe und in den angrenzenden Bereichen der Oberfläche auf ein Minimum reduziert werden. Nach Einbringen der Kerben kann die Schutzschicht inklusive den darauf haftenden Ablagerungen rückstandsfrei entfernt werden. Dadurch können Kerben mit besonders klar definierten Kanten und sauber angrenzenden Oberflächen erzielt werden.

Bei der Variante von Fig. 8B werden die Kerben K in den dünnen Probenabschnitt PA einseitig von derjenigen Seite eingebracht, die bereits ausgehend vom Probenkörper zurückgesetzt wurde, um den dünnen Probenabschnitt PA zu erzeugen. Nach dem Erzeugen der Kerben kann der Probenabschnitt dann von der gegenüberliegenden Rückseite noch weiter abgedünnt werden, gegebenenfalls so weit, dass die Kerben nach Abschluss des Abdünnens von der dargestellten Vorderseite zur nicht sichtbaren Rückseite hindurchgehen. Auch in dieser Variante kann gegebenenfalls temporär eine Schutzschicht aufgebracht werden, durch die hindurch die Kerben erzeugt werden.

Bei der Variante von Fig. 8C werden die Kerben K nach Fertigstellung des auf seine Zieldicke reduzierten dünnen Probenabschnitts PA eingebracht. Auch hierbei kann eine Schutzschicht genutzt werden, welcher dann eine zusätzliche Stabilisierungsfunktion zukommen kann.

Es ist möglich, die Kerben nur an wenigen Stellen einzubringen, etwa in Form von Scharen parallelen Kerben. Es ist auch möglich, einzelne Kerben oder alle Kerben als in Verlaufsrichtung unterbrochene Kerben zu gestalten, wie es schematisch in Fig. 9 gezeigt ist. Die parallelen Kerben können zusätzlich in Linienrichtung einen Versatz aufweisen, etwa einen Versatz um eine Einzelkerbenlänge. Es können auch mehrere Scharen paralleler Kerben eingebracht werden, die jeweils konkreten Zielpositionen zugeordnet sind. Dabei ist es normalerweise im Interesse möglichst kurzer Bearbeitungszeiten für die Erzeugung der Kerben sowie im Hinblick auf die gegenseitige Beeinflussung des abgetragenen Materials und der Stabilität sinnvoll, so wenig Kerben wie möglich zu applizieren, beispielsweise zwischen zwei und sechs Kerben bezogen auf einen Zielbereich.

Es ist möglich, den lonenstrahl so einzustrahlen, dass er während der gesamten Bearbeitungsdauer aus der gleichen Einstrahlungsrichtung einstrahlt. Es ist auch möglich, lonenbestrahlung mit einem azimutal oszillierenden lonenstrahl durchzuführen, also mit einem lonenstrahl, der während der Dauer der lonenbestrahlung seine Einstrahlungsrichtung periodisch oder aperiodisch über einen gewissen Einfallswinkelbereich variiert. Dies kann unter anderem im Sinne einer Reduktion eines möglicherweise auftretenden Curtaining sinnvoll sein. Auch bei diesen Varianten kann es hilfreich sein, wenn man von einer schnurgeraden Form von Kerben zu adaptierten Formen übergeht, beispielsweise zu einer Halbkreisform oder einer elliptischen Form. Ein Beispiel mit halbkreisförmig um den Zielbereich ZB angeordneten Kerben K1, K2 ist in Fig. 10 schematisch gezeigt. Die Einstrahlrichtung des lonenstrahls IB variiert bei der lonenstrahlbearbeitung periodisch, beispielsweise um ± 5° um eine Haupt-Einstrahlrichtung, so dass der lonenstrahl zu einem Zeitpunkt t₁ aus einer anderen Richtung kommt als zu einem früheren oder späteren Zeitpunkt t₂.

Im allgemeinen Fall kann die Lage und Form von Kerben sowie deren Anzahl variiert werden, um einen gewünschten Arbeitsablauf zu erreichen. Insbesondere können diese Parameter so variiert werden, dass bei einer nachfolgenden lonenstrahlbearbeitung eine möglichst hohe Ätzrate erreicht wird, um eine schnelle Probenpräparation zu fördern. Da die Abhängigkeit der Ätzrate vom Auftreffwinkel von Material zu Material unterschiedlich sein kann, können auch die optimierten Kerbengeometrien und -anzahlen für unterschiedliche Materialien unterschiedlich sein.

An der durch eine Kerbe sich öffnenden Flanke ergibt sich der lokale lonenauftreffwinkel als Summe des vertikalen lonenauftreffwinkels (der sich bei Änderung des Glanzwinkels verändert und bei konstantem Glanzwinkel konstant bleibt) und des azimutalen lonenauftreffwinkels (vgl. Fig. 10). Diese beiden Auftreffwinkel können so gewählt werden, dass sich eine möglichst hohe Ätzrate ergibt.

Generell ist kann es sinnvoll sein, abgestimmt auf das Maximum der winkelabhängigen Abtragungsrate einen optimalen Azimutalwinkel zu wählen. Dies kann auch durch Anordnung von Kerben nicht parallel zur Oberkante der Probe (vgl. Seite S in Fig. 1), sondern geneigt dazu oder durch Wahl eines relativen lonenauftreffwinkels bei der lonenstrahlnachbearbeitung erreicht werden. Die Einstrahlung der Ionen muss also nicht mehr oder weniger senkrecht zur Verlaufsrichtung einer Kerbe erfolgen, sondern es sind auch schräge Einstrahlungen möglich, z.B. so, dass Einstrahlrichtung und Kerbenverlauf in einem Winkel von 30° bis 60° zueinander liegen. Auf diese Weise können feste Stufenhöhen leicht (d.h. in Bruchteilen der typischen Stufenhöhe) vergrößert werden, etwa, um eine bestimmte Restdicke des elektronentransparenten Bereichs einzustellen.

Wie erwähnt sind auch Oszillationen des lonenstrahls um eine definierte Haupt-Einstrahlrichtung (zum Beispiel um ± 10°) möglich. Da in den meisten Fällen im Bereich des Maximums der Abtragungsrate die Änderung der Abtragrate mit dem Auftreffwinkel bei kleinen Änderungen um wenige Grad zunächst nur gering ist, ergeben sich durch eine entsprechend kleine Oszillation der Einstrahlrichtung während der lonenstrahlbearbeitung keine substanziellen Einbußen bei der erzielbaren Abtraggeschwindigkeit.

Da sich der Glanzwinkel des lonenstrahls analytisch vorhersagbar auf die Höhe der Terrassenstufe auswirkt, ist zusätzlich zu den vorher erwähnten Variationsmöglichkeiten oder kombiniert damit auch eine Variation des vertikalen Auftreffwinkels möglich, um eine gewünschte Zielabtragtiefe einzustellen. Damit können Unwägbarkeiten der Stufentiefe, welche durch eine allmähliche Verrundung der Kante der vorderen Flanke entstehen können (vgl. z.B. KT1 in Fig. 2D), auf Basis einer Restdickenbestimmung entgegengewirkt werden.

Im allgemeinen Fall ist es möglich, im zeitlichen Verlauf sowohl die azimutale als auch die vertikale Einstrahlrichtung gezielt so zu gestalten und gegebenenfalls zu variieren, dass eine vorgegebene, laserbearbeitete Initialkantenstruktur im Zielgebiet zur gewünschten, möglichst planparallelen Absenkung führt.

Wie bereits erläutert ist es auch möglich, die Kerben nicht als Kerben konstanter Breite auszuführen, sondern gegebenenfalls lokale Verdickungen oder ein graduelles Aufweiten vorzusehen (vgl. Fig. 7). Dadurch können die Dickentestbereiche für Messzwecke oder die optische Erfassung bereitgestellt werden (vgl. Fig. 7).

Mit den genannten und anderen im Rahmen der Erfindung möglichen Ansätzen kann erreicht werden, dass an einer beispielsweise durch Laserbearbeitung vorbearbeiteten Probe mit einem dünnen Probenabschnitt dieser lokal so konditioniert werden kann, dass die anschließende, darauf abgestimmte lonenbestrahlung in möglichst kurzer Zeit eine optimale, idealerweise nur wenige 10 nm dicke und im Zielbereich nicht perforierte Probe erzeugen kann. Zur Prozesskontrolle kann die erwähnte In-Line-Dickenmessung mithilfe gezielt vorgebbarer Dickentestbereiche genutzt werden. Als Dickenmarker kommen alternativ auch keilförmige Lamellen und/oder Kerben in Betracht, die in ihrer Breite variieren.

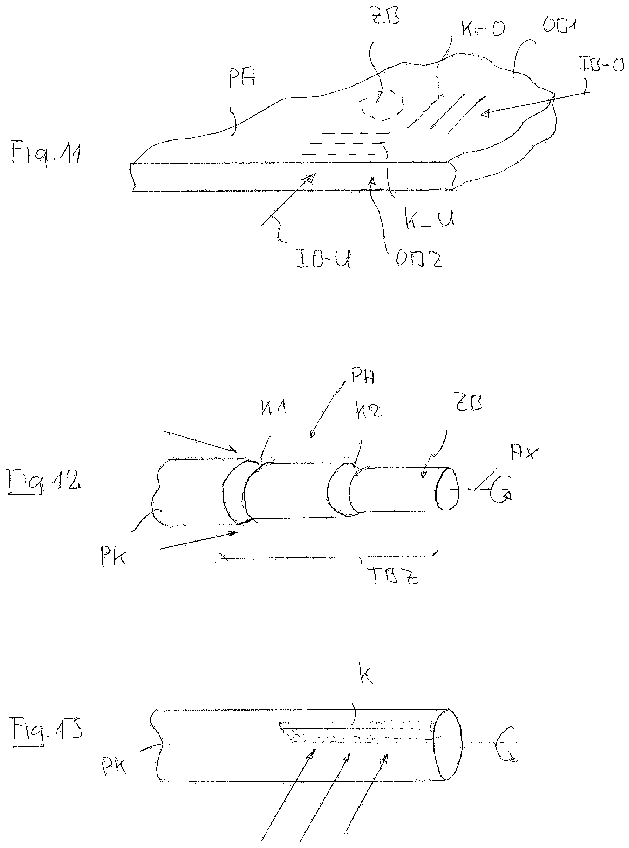

Fig. 11 zeigt ein weiteres Ausführungsbeispiel, bei dem ein plattenartiger Probenabschnitt PA beidseitig, d.h. sowohl an seiner ersten Oberfläche OB1 (Vorderseite) als auch an seiner gegenüberliegenden zweiten Oberfläche OB2 (Rückseite) mit einer Terrassenbildungszone versehen wird. Hierzu wurden an der ersten Oberfläche OB1 drei zueinander parallele Kerben K-O in der gezeigten Darstellung rechts neben dem Zielbereich ZB mittels eines fokussierten Laserstrahls eingebracht. An der gegenüberliegenden zweiten Oberfläche OB2 wurden drei zueinander parallele Kerben K-U eingebracht, deren geradlinige Verlaufsrichtungen senkrecht zu den geradlinigen Verlaufsrichtungen der Kerben K-O an der ersten Oberfläche OB1 verlaufen. Während der Phase der lonenstrahlbearbeitung wird ein lonenstrahl IB-O auf die erste Oberfläche OB1 in streifendem Einfall derart eingestrahlt, dass der Zielbereich ZB hinter den oberen Kerben K-O liegt. An der gegenüberliegenden Rückseite läuft die Einstrahlrichtung des unteren lonenstrahls IB-U im Wesentlichen senkrecht zur Einstrahlrichtung des anderen lonenstrahls in der Weise, dass der Zielbereich hinter den gestrichelt dargestellten unteren Kerben K-U liegt. Dadurch ergibt sich im vorgesehenen Untersuchungsbereich, insbesondere im Bereich des Zielbereichs ZB, ein Materialabtrag von beiden Seiten mit gegenseitiger Überlappung und loneneinstrahlung aus unterschiedlichen Einstrahlrichtungen, woraus eine gesteigerte mechanische Stabilität resultiert.

Mithilfe der beanspruchten Erfindung können lonenstrahlnachdünnprozesse so gesteuert werden, dass lokal gezielt und mit signifikant gegenüber herkömmlichen Prozessen gesteigerter Geschwindigkeit eine idealerweise nicht perforierte TEM-Probe entsteht, die im Zielbereich eine mit hoher Genauigkeit vorgebbare Restdicke mit geeigneter Elektronentransparenz aufweist.

Die Fig. 12 und 13 zeigen verschiedene Möglichkeiten zur Präparation einer Probe P, die für die Untersuchung der Mikrostruktur des Probenmaterials mit Hilfe der Atomsonden-Tomographie (LEAP) oder der Röntgentomographie bzw. Röntgenmikroskopie (XRM) präpariert werden soll.

Beim Ausführungsbeispiel in Fig. 12 hat der Probenkörper PK eine in Bezug auf eine zentrale Achse AX generell rotationssymmetrische Gestalt und ist zu Beginn der Präparation noch ein zylindrisches Materialstück. Bei dem Verfahren werden umlaufende Kerben K1, K2 durch Einstrahlung eines Laserstrahls bei gleichzeitiger Drehung des Probenkörpers um seine Achse AX eingebracht. Der Zielbereich ZB befindet sich am dargestellten freien Ende des Probenabschnitts PA. Dort soll die Probe besonders dünn sein und einen relativ geringen Durchmesser (z.B. wenige zehn Nanometer) haben. Die Kerben definieren eine Terrassenbildungszone TBZ, in der die Probe durch lonenbestrahlung stufenweise gedünnt bzw. im Durchmesser reduziert werden soll. Dies wird erreicht durch nachfolgende Einstrahlung von mindestens einem lonenstrahl IB im streifenden Einfall auf die zylindrisch gekrümmte Oberfläche des Probenabschnitts PA. Die durch Pfeile symbolisierten Einstrahlrichtungen der lonenstrahlen stehen hier in einem spitzen Winkel von beispielsweise 4 und 10° zur Achsrichtung der sich um diese Achse drehenden Probe, so dass ein entsprechender streifender Einfall auf die eindimensional gekrümmte Oberfläche vorliegt. Die Projektion der Einstrahlrichtung auf die Achse AX steht dabei senkrecht auf den Verlaufsrichtungen der umlaufenden Kerben. Im Bereich der Kerben bilden sich nach dem oben bereits beschriebenen Prinzip Stufen aus, die im Beispielsfall nach ausreichender Ätzdauer dazu führen, dass der Durchmesser in dem den Zielbereich ZB enthaltenen vorderen Abschnitt um etwa vier Stufenhöhen geringer ist als der Durchmesser in dem zylindrischen Abschnitt des Probenkörpers vor der ersten Kerbe K1. Es ist somit möglich, an einem ursprünglich zylindrischen Probenkörper eine gestufte Spitze bzw. eine stufenweise Durchmesserverjüngung zu präparieren.

Beim Ausführungsbeispiel von Fig. 13 verläuft eine Kerbe K parallel zur Achse AX des zylindrischen Probenkörpers PK. Wenn nun der Probenkörper während der lonenbestrahlung um seine Achse AX gedreht wird, kann Material vom zu präparierenden Ende des Probenkörpers ähnlich wie die Rinde von einem Baum abgeschält bzw. mittels lonenbestrahlung abgetragen werden. Die Umfangsgeschwindigkeit der rotierenden Oberfläche kann dabei z.B. so an die Fortschreitgeschwindigkeit der Stufen angepasst sein, dass diese Geschwindigkeiten etwas gleich groß sind.

Bei den bisher anhand von Figuren beschriebenen Beispielen wurden die Kerben jeweils mittels Laserbestrahlung mit einem fokussierten Laserstrahl erzeugt. Dies ist jedoch nicht zwingend.

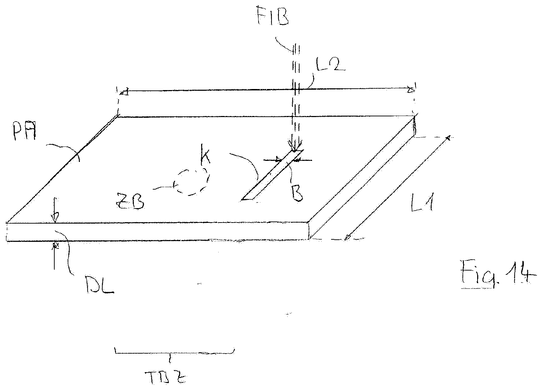

Fig. 14 zeigt ein Ausführungsbeispiel eines Probenabschnitts PA in Form einer planparallelen Platte sehr geringer Dicke DL, wie sie für sog. FIB-Lamellen typisch ist. Die Dicke DL kann beispielsweise in dem Bereich zwischen 500 nm und 1 µm liegen und die Kantenlängen L1 und L2 können im niedrigen Mikrometerbereich liegen, beispielsweise im Bereich um 20 µm (längere Seite) und um 5 µm (kürzere Seite). Der plattenförmige Probenabschnitt wurde mittels eines fokussierten lonenstrahls (FIB) aus einem größeren Materialstück des zu untersuchenden Materials herauspräpariert.

An der FIB-Lamelle wird mindestens eine Kerbe K in eine Terrassenbildungszone TBZ eingebracht, die den Zielbereich ZB enthält. Im Unterschied zu dem vorherigen Ausführungsbeispielen wird die Kerbe durch Bestrahlung der Oberfläche OB mit einem fokussierten lonenstrahl (FIB) in die Oberfläche eingebracht. Die Kerbenbreiten können hier deutlich kleiner sein als bei der Bearbeitung mit einem fokussierten Laserstrahl. Kerbenbreiten können im niedrigen oder mittleren Nanometerbereich liegen, beispielsweise im Bereich von 50 nm bis 250 nm und auch etwas darüber. Bei typischen Einstrahlbedingungen eines fokussierten, streifend einfallenden lonenbreitstrahls in einer nachfolgenden lonenstrahlbearbeitungsoperation, also z.B. bei Glanzwinkeln im Bereich von 5 bis 20°, können hinter der Kerbe Absenkungen des Oberflächenniveaus bzw. Stufenhöhen in der Größenordnung einiger 10 nm erreicht werden, z.B. im Bereich von 30 nm bis 100 nm oder darüber. Mit Hilfe einer oder mehrerer dieser Kerben, beispielsweise mit Hilfe von drei zueinander parallelen Kerben von jeweils 50 bis 100 nm Breite im Abstand von 100 nm bis 200 nm kann die Dicke DL des Probenabschnitts gezielt soweit reduziert werden, dass im Zielbereich die angestrebte Elektronentransparenz bei gleichzeitig vergleichsweise hoher mechanischer Stabilität vorliegt.

## Patentansprüche

1. Verfahren zur Präparation einer Probe (P) für die Mikrostrukturdiagnostik, worin durch materialabtragende Bearbeitung an einem Probenkörper ein Probenabschnitt (PA) präpariert und anschließend an dem Probenabschnitt ein Untersuchungsbereich erzeugt wird, welcher einen zu untersuchenden Zielbereich (ZB) umfasst, das Verfahren mit folgenden Schritten:
Erzeugen einer den Zielbereich umfassenden Terrassenbildungszone (TBZ) an mindestens einer Oberfläche (OB, OB1, OB2) des Probenabschnitts, wobei zur Erzeugung der Terrassenbildungszone neben dem Zielbereich durch materialabtragende Strahlbearbeitung mindestens eine Kerbe (K, K1, K2, K3) mit schräg zu der Oberfläche verlaufender vorderer Flanke (F1) und hinterer Flanke (F2) erzeugt wird; und
Abtragen von Material von der Oberfläche des Probenabschnitts (PA) im Bereich der Terrassenbildungszone (TBZ) mittels eines lonenstrahls (IB), welcher unter streifendem Einfall unter einem Winkel von weniger als 15° zwischen der Oberfläche des Probenabschnitts und der Einstrahlrichtung des lonenstrahls schräg zu einer Verlaufsrichtung der Kerbe (K, K1, K2, K3) derart auf die Oberfläche eingestrahlt wird, dass durch die Orientierung der hinteren Flanke (F2) schräg zur Oberfläche die Ionen des lonenstrahls mehr oder weniger senkrecht auf denjenigen Abschnitt der hinteren Flanke (F2) treffen, der durch die gegenüberliegende vordere Flanke (F1) nicht abgeschattet wird, dass der Zielbereich (ZB) in Einstrahlrichtung des lonenstrahls (IB) hinter der Kerbe liegt, und dass aufgrund von Terrassenbildung im Bereich hinter der Kerbe die Oberfläche im Wesentlichen parallel zum ursprünglichen Niveau der Oberfläche durch lonenstrahlbearbeitung zurückgesetzt wird.

2. Verfahren nach Anspruch 1, **dadurch gekennzeichnet, dass** eine Probe (P) präpariert wird, die für eine Mikrostrukturdiagnostik mittels Transmissionselektronenmikroskopie (TEM) geeignet ist, wobei in dem Probenabschnitt ein elektronentransparenter Untersuchungsbereich erzeugt wird, in welchem der Zielbereich (ZB) liegt.

3. Verfahren nach Anspruch 1 oder 2, **dadurch gekennzeichnet, dass** die Kerbe (K, K1, K2, K3) durch Laserstrahlbearbeitung in die Oberfläche (OB, OB1, OB2) eingebracht wird.

4. Verfahren nach einem der vorhergehenden Ansprüche, **dadurch gekennzeichnet, dass** in der Terrassenbildungszone (TBZ) mehrere mit Abstand (A) zueinander verlaufende Kerben (K1, K2) erzeugt werden, insbesondere zueinander parallel verlaufende Kerben, wobei vorzugsweise in der Terrassenbildungszone (TBZ) zwei, drei, vier, fünf oder sechs mit Abstand zueinander angeordnete Kerben erzeugt werden.

5. Verfahren nach Anspruch 4, **dadurch gekennzeichnet, dass** der Abstand (A) zwischen benachbarten Kerben an die Breite der Kerben (K1, K2) derart angepasst ist, dass der Abstand zwischen dem Doppelten und dem Zehnfachen, insbesondere zwischen dem Doppelten und dem Fünffachen der Breite einer einzelnen Kerbe liegt.

6. Verfahren nach Anspruch 4 oder 5, **dadurch gekennzeichnet, dass** die Kerben derart erzeugt werden, dass der Abstand zwischen unmittelbar benachbarten Kerben im Bereich von 20 µm bis 100 µm liegt.

7. Verfahren nach einem der vorhergehenden Ansprüche, **dadurch gekennzeichnet, dass** die Kerbe (K) derart erzeugt wird, dass eine Breite an der Oberfläche in einem Bereich von 10 µm bis 50 µm liegt.

8. Verfahren nach einem der vorhergehenden Ansprüche, **dadurch gekennzeichnet, dass** mindestens eine Kerbe (K3) erzeugt wird, welche eine in Verlaufsrichtung variierende Breite aufweist, wobei vorzugsweise zwischen dieser Kerbe und dem Zielbereich keine weitere Kerbe liegt.

9. Verfahren nach einem der vorhergehenden Ansprüche, **dadurch gekennzeichnet, dass** mindestens eine Kerbe (K3) erzeugt wird, welche einen nicht-geradlinigen Verlauf mit wechselnder Verlaufsrichtung aufweist, wobei vorzugsweise zwischen dieser Kerbe und dem Zielbereich (ZB) keine weitere Kerbe liegt.

10. Verfahren nach einem der vorhergehenden Ansprüche, **dadurch gekennzeichnet, dass** der Probenabschnitt (PA) beidseitig bearbeitet wird, wobei sowohl an einer ersten Oberfläche (OB1) des Probenabschnitts als auch an einer gegenüberliegenden zweiten Oberfläche (OB2) des Probenabschnitts mindestens eine Kerbe eingebracht wird, so dass auf beiden Oberflächen des Probenabschnitts jeweils eine Terrassenbildungszone entsteht, und dass danach an der ersten Oberfläche und der zweiten Oberfläche mittels eines lonenstrahls unter streifendem Einfall Material im Bereich der Terrassenbildungszone abgetragen wird.

11. Verfahren nach einem der vorhergehenden Ansprüche, **dadurch gekennzeichnet, dass** vor der materialabtragenden Strahlbearbeitung zur Erzeugung einer Kerbe eine Schutzschicht (SS) auf die Oberfläche aufgebracht wird, danach die Kerbe (K) in dem Probenabschnitt (PA) durch die Schutzschicht hindurch erzeugt wird und danach die Schutzschicht von der Oberfläche entfernt wird.

12. Verfahren nach einem der vorhergehenden Ansprüche, **dadurch gekennzeichnet, dass** beim Abtragen des Materials mittels lonenstrahl die Einstrahlrichtung des lonenstrahls (IB) in einer Azimutalrichtung und/oder in einer Vertikalrichtung während des Abtragens periodisch oder aperiodisch über einen Einfallswinkelbereich variiert wird.

13. Verfahren nach einem der vorhergehenden Ansprüche, **gekennzeichnet durch** eine In-Line-Dickenbestimmung zur Bestimmung der Dicke des Probenabschnitts im Bereich der Terrassenbildungszone während des Abtragens von Material mittels lonenstrahl.

14. Probe für die Mikrostrukturdiagnostik mit:
einem Probenabschnitt (PA), der einen Untersuchungsbereich aufweist, welcher einen zu untersuchenden Zielbereich (ZB) umfasst,
**dadurch gekennzeichnet, dass** an mindestens einer Oberfläche (OB) des Probenabschnitts (PA) neben dem Untersuchungsbereich mindestens eine Kerbe (K) mit schräg zu der Oberfläche des Probenabschnitts (PA) verlaufender vorderer Flanke (F1) und hinterer Flanke (F2) liegt und ein Oberflächenniveau eines an der dem Untersuchungsbereich abgewandten Seite der Kerbe liegenden ersten Oberflächenbereichs (OB1) höher ist als das Oberflächenniveau eines gegenüber dem ersten Oberflächenbereich (OB1) im Wesentlichen parallel zurückgesetzten, an die hintere Flanke (F2) angrenzenden zweiten Oberflächenbereichs (OB2) im Untersuchungsbereich.

15. Probe nach Anspruch 14, **dadurch gekennzeichnet, dass** der Untersuchungsbereich ein elektronentransparenter Bereich ist, wobei eine Probendicke an der dem elektronentransparenten Bereich abgewandten Seite der Kerbe (K) größer ist als im elektronentransparenten Bereich.

## Claims

1. A method for preparing a sample (P) for microstructure diagnosis, in which a sample portion (PA) is prepared on a sample body and then an investigation region, which comprises a target region (ZB) to be investigated, is produced by material-ablating machining, the method having the following steps:
producing a terrace formation zone (TBZ) comprising the target region on at least one surface (OB, OB1, OB2) of the sample portion, wherein, in order to produce the terrace formation zone adjacent to the target region, at least one notch (K, K1, K2, K3) with a front flank (F1) and a rear flank (F2) extending obliquely to the surface is produced by material-ablating beam machining; and
ablating material from the surface of the sample portion (PA) in the region of the terrace formation zone (TBZ) by means of an ion beam (IB), which is irradiated with glancing incidence at an angle of less than 15° between the surface of the sample portion and the direction of irradiation of the ion beam obliquely to a direction of extension of the notch (K, K1, K2, K3) onto the surface in such a manner that, due to the orientation of the rear flank (F2) oblique to the surface, the ions of the ion beam impinge more or less perpendicularly on that portion of the rear flank (F2) which is not shaded by the opposing front flank (F1), that the target region (ZB) is located behind the notch in the direction of irradiation of the ion beam (IB), and that, due to terrace formation in the region behind the notch, the surface is recessed substantially parallel to the original level of the surface by ion beam machining.

2. A method according to Claim 1, **characterised in that** a sample (P) is prepared which is suitable for microstructure diagnosis by means of transmission electron microscopy (TEM), wherein an electron-transparent investigation region, in which the target region (ZB) is located, is produced in the sample portion.

3. A method according to Claim 1 or 2, **characterised in that** the notch (K, K1, K2, K3) is introduced into the surface (OB, OB1, OB2) by laser beam machining.

4. A method according to one of the preceding claims, **characterised in that** a plurality of notches (K1, K2) spaced from one another, in particular extending parallel to one another, are produced in the terrace formation zone (TBZ), wherein two, three, four, five or six mutually spaced notches are preferably produced in the terrace formation zone (TBZ).

5. A method according to claim 4, **characterised in that** the spacing (A) between adjacent notches is adapted to the width of the notches (K1, K2) in such a manner that spacing is between two and ten times, in particular between two and five times, the width of an individual notch.

6. A method according to claim 4 or 5, **characterised in that** the notches are produced in such a manner that the spacing between directly adjacent notches is in the range from 20 µm to 100 µm.

7. A method according to one of the preceding claims, **characterised in that** the notch (K) is produced in such a manner that a width at the surface is in a range from 10 µm to 50 µm.

8. A method according to one of the preceding claims, **characterised in that** at least one notch (K3) is produced which has a width which varies in the direction of extension, wherein there is preferably no further notch between this notch and the target region.

9. A method according to one of the preceding claims, **characterised in that** at least one notch (K3) is produced which has a non-rectilinear course with a changing direction of extension, wherein there is preferably no further notch between this notch and the target region (ZB).

10. A method according to one of the preceding claims, **characterised in that** the sample portion (PA) is machined on both sides, wherein at least one notch is introduced both on a first surface (OB1) of the sample portion and on an opposing second surface (OB2) of the sample portion, such that a terrace formation zone in each case arises on both surfaces of the sample portion, and that thereafter material is ablated in the region of the terrace formation zone on the first and the second surfaces by means of an ion beam with glancing incidence.

11. A method according to one of the preceding claims, **characterised in that** a protective layer (SS) is applied onto the surface prior to material-ablating beam machining for producing a notch, thereafter the notch (K) is produced in the sample portion (PA) through the protective layer and thereafter the protective layer is removed from the surface.

12. A method according to one of the preceding claims, **characterised in that**, during ablation of the material by ion beam, the direction of irradiation of the ion beam (IB) is periodically or aperiodically varied during ablation in an azimuthal direction and/or in a vertical direction over a range of angles of incidence.

13. A method according to one of the preceding claims, **characterised by** in-line thickness determination to determine the thickness of the sample portion in the region of the terrace formation zone during the ablation of material by ion beam.

14. A sample for microstructure diagnosis with:
a sample portion (PA) which has an investigation region which comprises a target region (ZB) to be investigated,
**characterised in that** on at least one surface (OB) of the sample portion (PA), adjacent to the investigation region, there is at least one notch (K) with a front flank (F1) and a rear flank (F2) extending obliquely to the surface of the sample portion (PA) and a surface level of a first surface region (OB1) located on a side of the notch facing away from the investigation region is higher than the surface level of a second surface region (OB2) in the investigation region which is recessed substantially parallel to the first surface region (OB1) and adjoins the rear flank (F2).

15. A sample according to claim 14, **characterised in that** the investigation region is an electron-transparent region, wherein a sample thickness on the side of the notch (K) facing away from the electron-transparent region is greater than in the electron-transparent region.

## Revendications

1. Procédé de préparation d'un échantillon (P) pour le diagnostic de microstructure dans lequel une section d'échantillon (PA) est préparée au moyen d'un traitement par enlèvement de matière sur un corps d'échantillon, puis dans lequel est créée sur la section d'échantillon une zone d'examen qui comprend une zone cible (ZB) à examiner, avec les étapes suivantes :
Création d'une zone de formation de terrasses (TBZ) comprenant la zone cible sur au moins une surface (OB, OB1, OB2) de la section d'échantillon, sachant que pour créer la zone de formation de terrasses à côté de la zone cible, au moins une encoche (K, K1, K2, K3) à flanc avant (F1) et à flanc arrière (F2) s'étendant en biais par rapport à la surface, au moyen d'un traitement au faisceau par enlèvement de matière ; et enlèvement de matière de la surface de la section d'échantillon (PA) dans la zone de formation de terrasses (TBZ) au moyen d'un faisceau ionique (IB) qui est projeté sur la surface en incidence rasante à un angle inférieur à 15° entre la surface de la section d'échantillon et la direction d'irradiation du faisceau ionique en biais par rapport au sens du tracé de l'encoche (K, K1, K2, K3) de telle sorte qu'au moyen de l'orientation du flanc arrière (F2) en biais par rapport à la surface, les ions du faisceau ionique arrivent de manière plus ou moins perpendiculaire sur la section du flanc arrière (F2) qui n'est pas dans l'ombre du flanc avant en face (F1), que la zone cible (ZB) se trouve derrière l'encoche dans le sens d'irradiation du faisceau ionique (IB) et qu'en raison de la formation de terrasses dans la zone derrière l'encoche, la surface est décalée essentiellement parallèlement par rapport au niveau initial de la surface, par le traitement au faisceau ionique.

2. Procédé selon la revendication 1, **caractérisé en ce qu'**est préparé un échantillon (P) qui convient au diagnostic de microstructure par microscopie électronique en transmission (MET), sachant qu'est créée dans la section d'échantillon une zone d'examen transparente aux électrons dans laquelle se trouve la zone cible (ZB).

3. Procédé selon la revendication 1 ou 2, **caractérisé en ce que** l'encoche (K, K1, K2, K3) est réalisée dans la surface (OB, OB1, OB2) par traitement au faisceau laser.

4. Procédé selon une des revendications précédentes, **caractérisé en ce que** sont créées dans la zone de formation de terrasses (TBZ) plusieurs encoches (K1, K2) séparées entre elles par un écart (A), notamment plusieurs encoches parallèles entre elles, sachant que deux, trois, quatre, cinq ou six encoches disposées séparées entre elles par un écart sont créées de préférence dans la zone de formation de terrasses (TBZ).

5. Procédé selon la revendication 4, **caractérisé en ce que** l'écart (A) entre les encoches voisines est adapté à la largeur des encoches (K1, K2) de telle sorte que l'écart se situe entre le double et le décuple, notamment entre le double et le quintuple de la largeur d'une encoche.

6. Procédé selon la revendication 4 ou 5, **caractérisé en ce que** les encoches sont créées de telle sorte que l'écart entre les encoches directement voisines se situe entre 20 µm et 100 µm.

7. Procédé selon une des revendications précédentes, **caractérisé en ce que** l'encoche (K) est créée de telle sorte que la largeur à la surface se situe entre 10 µm et 50 µm.

8. Procédé selon une des revendications précédentes, **caractérisé en ce qu'**est créée au moins une encoche (K3) qui présente une largeur variant dans le sens du tracé, sachant que de préférence, aucune autre encoche ne se trouve entre cette encoche et la zone cible.

9. Procédé selon une des revendications précédentes, **caractérisé en ce qu'**est créée au moins une encoche (K3) qui présente un tracé non rectiligne avec sens de tracé changeant, sachant que de préférence, aucune autre encoche ne se trouve entre cette encoche et la zone cible (ZB).

10. Procédé selon une des revendications précédentes, **caractérisé en ce que** la section d'échantillon (PA) est traitée des deux côtés, sachant qu'au moins une encoche est réalisée aussi bien sur une première surface (OB1) de la section d'échantillon que sur une seconde surface (OB2) de la section d'échantillon, située en face, de sorte qu'une formation de terrasses se forme respectivement sur les deux surfaces de la section d'échantillon et qu'ensuite de la matière est enlevée dans la zone de formation de terrasses sur la première surface et la seconde surface au moyen d'un faisceau ionique en incidence rasante.

11. Procédé selon une des revendications précédentes, **caractérisé en ce qu'**avant le traitement au faisceau par enlèvement de matière pour créer une encoche, une couche protectrice (SS) est appliquée sur la surface, qu'ensuite, l'encoche (K) est créée dans la section d'échantillon (PA) à travers la couche protectrice, puis que la couche protectrice est retirée de la surface.

12. Procédé selon une des revendications précédentes, **caractérisé en ce que** lors de l'enlèvement de matière au moyen du faisceau ionique, le sens d'irradiation du faisceau ionique (IB) est varié périodiquement ou apériodiquement sur une plage d'angles incidents, dans un sens azimutal et/ou un sens vertical.

13. Procédé selon une des revendications précédentes, **caractérisé par** une détermination In-Line de l'épaisseur, destinée à déterminer l'épaisseur de la section d'échantillon dans la zone de formation des terrasses pendant l'enlèvement de matière au moyen du faisceau ionique.

14. Échantillon pour le diagnostic de microstructure avec :
une section d'échantillon (PA) qui présente une zone d'examen qui comprend une zone cible (ZB) à examiner,
**caractérisé en ce que** se situe, sur au moins une surface (OB) de la section d'échantillon (PA) à côté de la zone d'examen, au moins une encoche (K) à flanc avant (F1) et à flanc arrière (F2) s'étendant en biais par rapport à la surface de la section d'échantillon (PA) et qu'un niveau de surface d'une première zone de surface (OB1) située sur le côté de l'encoche, opposé à la zone d'examen est plus élevé que le niveau de surface d'une seconde zone de surface (OB2) dans la zone d'examen, avoisinant le flanc arrière (F2), décalée essentiellement parallèlement par rapport à la première zone de surface (OB1).

15. Échantillon selon la revendication 14, **caractérisé en ce que** la zone d'examen est une zone transparente aux électrons, sachant qu'une épaisseur d'échantillon sur le côté de l'encoche (K), opposé à la zone transparente aux électrons est supérieure à celle dans la zone transparente aux électrons.
